# EUROPÄISCHE PATENTANMELDUNG

(11) **EP 3 795 924 A1**
(43) Veröffentlichungstag der Anmeldung: **24.03.2021**
(21) Anmeldenummer: 19198529.0
(22) Anmeldetag: 20.09.2019
(51) Int. Cl.: F24S 70/20

(54) **VERFAHREN ZUM BEARBEITEN EINER TRANSPARENTEN DECKPLATTE UND DECKPLATTE**

(71) Anmelder: (CNBM) Bengbu Design & Research Institute for Glass Industry Co., Ltd., 233010 Bengbu (CN)
(72) Erfinder: Die Erfindernennung liegt noch nicht vor
(74) Vertreter: Gebauer, Dieter Edmund

(57) **Zusammenfassung**

Die Erfindung betrifft ein Verfahren zum Bearbeiten einer transparenten Deckplatte (10) für einen Flächenkörper (1), welches umfasst:
a) Bereitstellen einer transparenten Deckplatte (10) mit einer Außenseite (27), welche einer äußeren Umgebung zugewandt sein soll, und einer gegenüberliegenden Innenseite (28), wobei die Deckplatte (10) einen strukturierten Bereich (15) mit einer lichtstreuenden Struktur in mindestens einer Deckplattenfläche (11, 13), gewählt aus Außenfläche (11) und Innenfläche (13) der Deckplatte (10), aufweist, oder alternativ ein strukturierter Bereich (15) ausgebildet wird,
b) teilflächiges Ausbilden mindestens einer optischen Interferenzschicht (16) auf einer Deckplattenseite (27, 28), gewählt aus Außenseite (27) und Innenseite (28), welches umfasst:
b1) teilflächiges Aufbringen einer Maske (24) auf die Deckplatte (10), wobei in senkrechter Sicht durch die Deckplatte (10) die Maske (24) einen ersten Bereich (22) der Deckplattenfläche (11, 13) der Deckplattenseite (27, 28) nicht überdeckt und einen zweiten Bereich (23) der Deckplattenfläche (11, 13) der Deckplattenseite (27, 28) überdeckt, und der erste Bereich (22) und der zweite Bereich (23) in Überdeckung zu dem, gegebenenfalls noch auszubildenden, strukturierten Bereich (15) angeordnet sind,
b2) Aufbringen mindestens einer optischen Interferenzschicht (16) zur Reflexion von Licht innerhalb eines vorgegebenen Wellenlängenbereichs auf die Deckplatte (10) auf der gewählten Deckplattenseite (27, 28), wobei die optische Interferenzschicht (16) in senkrechter Sicht durch die Deckplatte (10) in Überdeckung zur Maske (24) und in Überdeckung zum ersten Bereich (22) der Deckplattenfläche (11, 13) aufgebracht wird,
b3) Entfernen der Maske (24), wobei die in senkrechter Sicht in Überdeckung zur Maske (24) befindliche optische Interferenzschicht (16) mitentfernt wird.

## Beschreibung

Die vorliegende Erfindung liegt auf dem technischen Gebiet der Fertigung von lichtabsorbierenden Flächenkörpern, wie Solarmodule und Solarkollektoren, sowie von passiven Flächenkörpern, die als integrierte Bestandteile einer Gebäudehülle oder freistehenden Wand dienen sollen und lediglich eine bauliche Funktion erfüllen.

Solarmodule zur fotovoltaischen Energieerzeugung aus Sonnenlicht und Solarkollektoren zur Umwandlung von Sonnenlicht in Wärmeenergie sind aus dem Alltagsleben hinlänglich bekannt. Hier und im Weiteren werden Solarmodule und Solarkollektoren gemeinsam als "lichtabsorbierende Flächenkörper" bezeichnet. Lichtabsorbierende Flächenkörper dienen zur Erzeugung von Energie aus Sonnenlicht oder zur Umwandlung von Sonnenlicht in Wärmeenergie. Diese werden auch als "aktive" Flächenkörper bezeichnet, im Gegensatz zu "passiven" Flächenkörpern, die hierzu weder geeignet noch bestimmt sind.

Ein Solarmodul umfasst eine fotoaktive Halbleiterschicht, welche der direkten Umwandlung von Sonnenlicht in elektrischen Strom dient. Der Begriff "Dünnschichtsolarmodul" bezieht sich auf Schichtensysteme mit Dicken von nur wenigen Mikrometern, die ein Trägersubstrat für eine ausreichende mechanische Festigkeit benötigen. Bekannte Trägersubstrate bestehen meist aus Glas oder Kunststoff und können in Abhängigkeit von der jeweiligen Schichtdicke und den spezifischen Materialeigenschaften als starre Platten oder biegsame Folien ausgestaltet sein. Bekannt ist es, Dünnschicht-solarmodule in Form von Verbundscheiben auszubilden, bei denen sich die fotoaktive Halbleiterschicht zwischen zwei meist gläsernen Einzelscheiben befindet, die durch eine thermoplastische Zwischenschicht fest miteinander verbunden sind. Durch die Deckscheibe (z.B. Deckglas) kann Sonnenlicht auf die fotoaktive Halbleiterschicht treffen.

Solarkollektoren umfassen typischer Weise ein Gehäuse mit einem Absorber und einem in einem Rohrsystem zirkulierenden Wärmeträger (Fluid). Das Gehäuse ist lichteintrittsseitig durch eine Deckplatte verschlossen. Der Absorber wird durch Sonnenlicht erwärmt, welches durch die Deckplatte (z.B. Deckglas) hindurchtritt, und gibt seine Energie an den Wärmeträger ab, der mit einem entfernt vom Solarkollektor angeordneten Pufferspeicher thermisch gekoppelt ist, welcher die Wärmeenergie nutzbar macht. In Freiflächenanlagen kann ein großer Zuwachs an lichtabsorbierenden Flächenkörpern, vor allem Solarmodulen, beobachtet werden. Jedoch bewegen sich Anwendungen im gebäudeintegrierten Umfeld derzeit noch in weit kleinerem Rahmen. Angesichts verstärkter Bemühungen für dezentrale Energielösungen entsteht ein konkreter Bedarf für die Anwendung als integrierte Bestandteile von Gebäudehüllen, beispielsweise als Fassaden, Fenster- oder Dachelemente. Weitere Anwendungsbereiche sind freistehende Wände wie Lärmschutzwände (Straße, Schiene), Sichtschutzwände im Außenbereich oder Wände für Gewächshäuser.

Diese neue Anwendungen stellen völlig neue Anforderungen an lichtabsorbierende Flächenkörper, insbesondere im Hinblick auf Ästhetik, Lebensdauer und weitere Funktionalitäten wie Abdichtung und Wärmeisolation. So sollen verschiedene Formen, Größen und Farben zur Verfügung stehen und es soll ein möglichst homogener Farbeindruck vermittelt werden. Hierbei gibt es jedoch technische Probleme, die mit der eigentlichen Funktionalität lichtabsorbierender Flächenkörper in Konflikt stehen. Ein idealer lichtabsorbierender Flächenkörper wäre hinsichtlich der Wirkungsgradoptimierung ein schwarzer Körper, der das auftreffende Sonnenlicht vollständig absorbiert, um einfallende Strahlungsenergie optimal zu verwerten. Jedoch wird von jedem realen Körper auftreffende Strahlung reflektiert und absorbierte Strahlung remittiert, wobei der Farbeindruck im menschlichen Auge grundsätzlich aus der spektral selektierten Reflexion und der Remission von sichtbarem Licht entsteht. Wird ein lichtabsorbierender Flächenkörper farbig gestaltet, d.h. soll im menschlichen Auge ein Farbeindruck erzeugt werden, der vom idealen schwarzen Körper verschieden ist, reduziert man bei einem Solarmodul zwingend die Intensität des im optisch aktiven Halbleiter absorbierten Lichts und damit die elektrische Leistung bzw. den Wirkungsgrad des Solarmoduls. Bei einem Solarkollektor sinkt gleichermaßen die vom Absorber aufgenommene Wärme und der Wirkungsgrad des Solarkollektors wird vermindert.

Solarmodulen und Solarkollektoren ist gemein, dass die lichteintrittsseitige Deckplatte für die Erzielung einer Farbwirkung genutzt werden kann. Hierzu sind verschiedene Verfahren bekannt.

Aus der internationalen Patentanmeldung WO 2014/045141 ist die Verwendung eines optischen Filters aus einem Vielfachstapel von mindestens drei bis zu neun Interferenzschichten auf der Innenseite eines Deckglases bekannt. Die optische Filterschicht reflektiert einen definierten Spektralbereich des Sonnenlichts, wodurch die Farbwirkung entsteht. Gezeigt ist auch die Verwendung von diffus streuendem Deckglas, wobei sich die optische Interferenzschicht und die aufgeraute Seite des Deckglases auf verschiedenen Seiten des Deckglases befinden (Interferenzschicht innen, Aufrauung außen) und die optischen und strukturellen Eigenschaften des Deckglases nicht weiter beschrieben sind. Der farbliche Eindruck wird durch die Oberflächenstrukturierung homogenisiert. Die Winkelstabilität wird jedoch über die komplexe Einstellung spezieller Reflexionsspektren durch den Schichtaufbau aus Vielfachschichten erreicht. Da die wahrgenommene Farbe in wesentlicher Weise von den Schichtdicken und Brechungsindizes abhängt, müssen die einzelnen Interferenzschichten möglichst homogen (d.h. mit gleichmäßiger Schichtdicke) abgeschieden werden. Der Wirkungsgradverlust bei der Farbgebung durch eine optische Interferenzschicht ist akzeptabel. Die Serienproduktion von Vielfachschichten mit bis zu 9 Schichten mit genau eingestellten Brechungsindizes und Schichtdicken auf Flächen von einem oder mehrern Quadratmetern ist jedoch technologisch sehr anspruchsvoll und mit hohen Kosten verbunden.

Bekannt ist auch die Verwendung von bionischen Verfahren, bei denen Nanostrukturen erzeugt werden, die denen von Schmetterlingen gleichen (siehe Fraunhofer, Bläsi et al. 33rd European PV Solar Energy Conference and Exhibition, 24-29 September 2017, Amsterdam, The Netherlands)*.* Diese Verfahren sind sehr aufwändig und kostenintensiv und eignen sich noch nicht für die industrielle Serienfertigung von großflächigen Solarmodulen und Solarkollektoren.

Bekannt ist ferner das Aufbringen von Farben auf Deckgläser durch keramischen Siebdruck oder die Verwendung von organischen Glasfarben. Dies sind vergleichsweise preiswerte Technologien, die auch ein breites Spektrum von Farben erzeugen können. Zudem ist der Farbeindruck nur wenig winkelabhängig. Jedoch sind die Farbschichten als solche grundsätzlich opak und weitgehend lichtabsorbierend, so dass der Wirkungsgradverlust zwangsläufig sehr hoch ist. Dies gilt insbesondere für helle Farbtöne, die in aller Regel zu einem inakzeptablen Wirkungsgradverlust führen.

Insofern bietet derzeit nur die Verwendung von optischen Interferenzschichten die Möglichkeit, bei einem lichtabsorbierenden Flächenkörper mit akzeptablem Wirkungsgradverlust eine Farbwirkung zu erzielen. Bislang ist jedoch nur die einfarbige Gestaltung des Deckglases mittels einer optischen Interferenzschicht bekannt, entsprechend dem Spektralbereich, der durch die optische Interferenzschicht reflektiert wird. Die Farbwirkung ergibt sich typischer Weise durch eine Kombination der reflektierten Farbe und der Farbe des Hintergrunds. Da die optische Interferenzschicht vollflächig im sichtbaren Bereich des Flächenkörpers angeordnet ist, hat der Flächenkörper, abhängig von der Farbe des Hintergrunds, im Wesentlichen eine selbe Farbe. Durch die einfarbige Gestaltung des Flächenkörpers wird die gestalterische Freiheit jedoch erheblich eingeschränkt.

Demgegenüber besteht die Aufgabe der vorliegenden Erfindung darin, einen mehrfarbigen, insbesondere zweifarbigen, Flächenkörper zur Verfügung zu stellen. Der Flächenkörper soll in der industriellen Serienfertigung einfach und mit relativ kurzen Fertigungszeiten unter Anwendung gängiger Verfahren herstellbar sein. Die mehrfarbige Farbgebung des Flächenkörpers soll den Wirkungsgrad eines lichtabsorbierenden Flächenkörpers nur geringfügig beeinträchtigen. Zudem sollen die Farben möglichst wenig vom Betrachtungs- und Einstrahlwinkel abhängen, da ansonsten bei der Verwendung im gebäudeintegrierten Umfeld die Farben stark vom Ort des Betrachters bzw. Sonnenstand abhängen würden. Für eine industrielle Serienfertigung ist es zudem wichtig, dass die Flächenkörper auf großen Flächen, sowie zu akzeptablen Kosten und mit zufriedenstellender Homogenität herstellbar sind.

Im Hinblick auf die konkrekte Gestaltung einer Fassade, insbesondere funktionaler Elemente wie Fenster, Türen und Balkone, kann es erforderlich sein, dass farbige Flächenkörper in verschiedenen Größen und Formen benötigt werden. Bei lichtabsorbierenden Flächenkörpern ergibt sich das Problem, dass deren Herstellung in verschiedenen Größen und Formen technisch möglich ist, jedoch kleinere und nicht rechteckige Formen zu erheblichen Mehrkosten führen, was wirtschaftlich nicht erwünscht ist. Um das Problem zu beheben wäre denkbar, Fassadenelemente aus Blech oder anderen herkömmlichen Baumaterialien zu verwenden. Hier gibt es aber ein technisches und gestalterisches Problem, das in der Natur der Farberzeugung liegt. Tatsächlich kann sich die Farbe von lichtabsorbierenden Flächenkörpern, je nach Ursprung der Farbe (Absorption/Remission, Interferenz, Brechung) bei unterschiedlichen Beleuchtungsverhältnissen, insbesondere abhängig von der Art des Lichtes (diffus, direkt, Lichtfarbe), sowie durch eine Änderung des Einstrahlwinkels und/oder Beobachtungswinkels verändern. Wenn die Fassadenelemente aus anderen Materialien als die farbigen lichtabsorbierenden Flächenkörper bestehen, entstehen hierdurch typischerweise Farbkontraste, die aus gestalterischen Gesichtspunkten unerwünscht sind. Demnach wäre es wünschenswert, auch über passive Fassadenelemente zu verfügen, welche diese Nachteile vermeiden und in einfacher Weise eine mehrfarbige Farbgestaltung ermöglichen.

Diese und weitere Aufgaben werden nach dem Vorschlag der Erfindung durch ein Verfahren zum Bearbeiten einer transparenten Deckplatte für einen Flächenkörper, ein Verfahren zum Herstellen eines Flächenkörpers, sowie eine transparente Deckplatte und einen Flächenkörper mit einer transparenter Deckplatte gemäß den nebengeordneten Patentansprüchen gelöst. Vorteilhafte Ausgestaltungen der Erfindung sind durch die Merkmale der Unteransprüche angegeben.

Im Sinne vorliegender Erfindung wird als "Flächenkörper" ein flächig-ausgedehnter, vorzugsweise planarer, Körper mit einer der äußeren Umgebung zugewandten, transparenten Deckplatte verstanden, bei dem es sich um einen lichtabsorbierenden Flächenkörper, wie ein Solarmodul oder ein Solarkollektor, oder um einen passiven Flächenkörper, der lediglich eine bauliche Funktion erfüllt und nicht zur Erzeugung und Umwandlung von Energie auf Basis von Sonnenlicht geeignet ist, handeln kann. Als Solarmodul kann grundsätzlich jede Art von Solarmodul realisiert werden, insbesondere ein Silizium-basiertes Solarmodul auf Wafer-Basis oder ein Dünnschichtsolarmodul mit in monolithisch integrierter Form serienverschalteten Solarzellen.

Der Flächenkörper verfügt über eine transparente Deckplatte (z.B. Deckglas), die lichteintrittsseitig angeordnet ist und den Durchtritt von Sonnenlicht in das Innere des Flächenkörpers ermöglicht. Generell weist der Flächenkörper rückseitig, d.h. auf der von der Lichteintrittsseite abgewandten Seite, eine oder typischer Weise mehrere Komponenten auf, die hier und im Weiteren gemeinsam durch den Begriff "Rückseitenelement" bezeichnet werden. Das vorzugsweise opake Rückseitenelement ist mit der transparenten Deckplatte vorzugsweise, jedoch nicht zwingend, fest verbunden. Das Rückseitenelement kann eine oder mehrere Farben aufweisen, welche sich typischer Weise durch dessen Komponenten ergeben. Die Hintergrundfarbe des Flächenkörpers ist durch die Farbe des Rückseitenelements gegeben.

Bei einem Solarmodul umfasst das Rückseitenelement die Solarzellen und weitere elektrische Komponenten wie streifenförmige Sammelleiter (Busbars) und, je nach Bauweise, eine Abdeckung oder Bodenplatte. Typischer Weise ist die Bodenplatte mit Solarzellen über eine thermoplastische Zwischenschicht mit der Deckplatte fest verbunden. Die Farbe des Rückseitenelements ist bei einem Solarmodul im Wesentlichen durch die Farbe der Solarzellen gegeben. Bei Dünnschichtsolarmodulen ist der optisch aktive Zellbereich meist schwarz, anthrazitgrau oder mit Restfarbtönen von dunklen Blau- und Grüntönen versehen. Bei Siliziumwafermodulen ist der optisch aktive Zellbereich meist blau. Bei einem Solarkollektor umfasst das Rückseitenelement typischer Weise ein Gehäuse, einen Absorber und einen Wärmeträger (Fluid) in Rohren. Bei Solarkollektoren ist das Rückseitenelement typischer Weise schwarz. Bei einem passiven Flächenkörper ist das Rückseitenelement typischer Weise opak und beispielsweise schwarz.

Farbige Solarmodule, deren Deckplatte mindestens einen strukturierten Bereich und mindestens eine optische Interferenzschicht aufweist, sind in den nicht-veröffentlichten europäischen Patentanmeldungen EP18186153.5 und EP18186161.8 beschrieben. Hinsichtlich Aufbau, Funktion und Verwendung dieser Solarmodule wird auf die Offenbarung dieser beiden europäischen Patentanmeldungen vollumfänglich Bezug genommen.

Vorzugsweise werden farbige passive Fassadenelemente in einer Fassade in Kombination mit farbigen Solarmodulen verwendet. Farbige passive Fassadenelemente sind in der nicht-veröffentlichten europäischen Patentanmeldung EP 18186175.8 beschrieben. Hinsichtlich Aufbau, Funktion und Verwendung von Fassadenelementen wird auf die Offenbarung dieser europäischen Patentanmeldung vollumfänglich Bezug genommen.

Erfindungsgemäß ist ein Verfahren zum Bearbeiten einer transparenten Deckplatte für einen Flächenkörper gezeigt.

Das Verfahren umfasst das Bereitstellen einer transparenten Deckplatte mit einer Außenseite, welche einer äußeren Umgebung zugewandt sein soll, und einer gegenüberliegenden Innenseite. Dementsprechend weist die Deckplatte zwei gegenüberliegende Deckplattenflächen auf, nämlich eine Außenfläche, welche der Außenseite zugeordnet ist und eine Innenfläche, welche der Innenseite zugeordnet ist. Die Deckplatte weist einen strukturierten Bereich mit einer lichtstreuenden Struktur in mindestens einer Deckplattenfläche, gewählt aus Außen- und Innenfläche, auf. Der strukturierte Bereich weist eine lichtstreuende Struktur auf, wie weiter unten näher erläutert wird. Der strukturierte Bereich kann aus einem einzelnen Abschnitt der Deckplattenfläche bestehen. Gleichermaßen ist es möglich, dass der strukturierte Bereich mehrere Abschnitte der Deckplattenfläche umfasst, die voneinander räumlich getrennt angeordnet sind. Vorzugsweise weist die Deckplattenfläche vollflächig einen strukturierten Bereich auf, gegebenenfalls mit Ausnahme eines Randbereichs, der keinen strukturierten Bereich aufweist.

Alternativ ist es möglich, dass eine nicht-strukturierte transparente Deckplatte bereitgestellt wird, wobei mindestens ein strukturierter Bereich mit einer lichtstreuenden Struktur in mindestens einer Deckplattenfläche, gewählt aus Außen- und Innenfläche, ausgebildet wird. Das Ausbilden des strukturierten Bereichs kann zeitlich vor oder nach dem nachfolgend beschriebenenen teilflächigen Ausbilden mindestens einer optischen Interferenzschicht erfolgen.

Das Verfahren umfasst weiterhin das teilflächige Ausbilden mindestens einer optischen Interferenzschicht auf einer Deckplattenseite, gewählt aus Außen- und Innenseite.

Als "teilflächig" wird im Sinne vorliegender Erfindung die nicht vollständige Überdeckung der Deckplattenfläche der Deckplattenseite verstanden, bezogen auf eine senkrechte Sicht durch die Deckplatte, im Unterschied zu "vollflächig", was eine vollständige Überdeckung angibt. Ist eine teilflächige Schicht direkt auf die Deckplattenfläche aufgebracht, bedeckt die Schicht die Deckplattenfläche nur teilweise, nicht vollständig. Ist eine vollflächige Schicht direkt auf die Deckplattenfläche aufgebracht, bedeckt die Schicht die Deckplattenfläche vollständig. Ist die Schicht nicht direkt auf die Deckplattenfläche aufgebracht, sondern befinden sich eine oder mehrere weitere Schichten dazwischen, gilt dies in senkrechter Sicht durch die Deckplattenfläche in entsprechender Weise für die (orthogonale) Projektion der Schicht auf die Deckplattenfläche, wobei anstelle "Bedeckung" der Begriff "Überdeckung" verwendet wird. Eine Deckplattenfläche kann in einen von einer Schicht überdeckten Bereich und einen nicht überdeckten Bereich aufgeteilt werden. Ein "Bereich" kann aus einem zusammhängenden Abschnitt oder mehreren nicht zusammenhängenden Abschnitten der Deckplattenfläche bestehen. Die Deckplattenfläche kann aus dem überdeckten Bereich und nicht überdeckten Bereich zusammengesetzt sein, wobei es gleichermaßen möglich ist, dass der überdeckte Bereich und nicht überdeckte Bereich nur einen Teil der Deckplattenfläche betreffen, wobei beispielsweise ein umlaufender Randbereich der Deckplattenfläche ausgenommen ist. Vorteilhaft ist der nicht überdeckte Bereich der Deckplattenfläche innenliegend angeordnet, d.h. ist vollständig von einem überdeckten Bereich der Deckplattenfläche umgeben.

Das teilflächige Ausbilden mindestens einer optischen Interferenzschicht auf der gewählten Deckplattenseite umfasst das Aufbringen einer Maske auf die Deckplatte auf der gewählten Deckplattenseite, wobei in senkrechter Sicht durch die Deckplatte die Maske einen ersten Bereich der Deckplattenfläche der Deckplattenseite nicht überdeckt und einen zweiten Bereich der Deckplattenfläche der Deckplattenseite überdeckt. Zudem sind der erste Bereich und der zweite Bereich in senkrechter Sicht durch die Deckplatte in Überdeckung zu dem bereits ausgebildeten oder gegebenenfalls noch auszuildenden strukturierten Bereich angeordnet. Vorteilhaft weisen der komplette erste Bereich und der komplette zweite Bereich in senkrechter Sicht durch die Deckplatte einen Überlapp mit dem strukturierten Bereich auf. Die Maske kann unmittelbar (d.h. ohne weitere Zwischenschicht) auf der Deckplattenfläche angeordnet werden. Möglich ist jedoch, dass sich eine oder mehrere Zwischenschichten zwischen der Maske und der Deckplattenfläche befinden.

Anschließend wird mindestens eine (erste) optische Interferenzschicht zur Reflexion von Licht innerhalb eines vorgegebenen bzw. vorgebbaren Wellenlängenbereichs auf die Deckplatte auf der gewählten Deckplattenseite aufgebracht, wobei die optische Interferenzschicht in senkrechter Sicht durch die Deckplatte in Überdeckung zur Maske (d.h. in Überdeckung zum zweiten Bereich der Deckplattenfläche) und in Überdeckung zu dem von der Maske nicht überdeckten ersten Bereich der Deckplattenfläche aufgebracht wird. Die optische Interferenzschicht kann unmittelbar (d.h. ohne weitere Zwischenschicht) auf der Maske sowie Deckplattenfläche angeordnet werden. Möglich ist jedoch, dass sich eine oder mehrere Zwischenschichten dazwischen befinden. Vorzugsweise wird die optische Interferenzschicht auf die komplette, teilflächig mit der Maske bedeckte Deckplattenfläche aufgebracht.

Anschließend wird die Maske entfernt wobei die in senkrechter Sicht in Überdeckung zur Maske befindliche optische Interferenzschicht (die Maske z.B. direkt bedeckende optische Inferenzschicht) mitentfernt wird.

Wie hier und im Weiteren verwendet, bezieht sich der Ausdruck "senkrechte Sicht durch die Deckplatte" auf eine orthogonale Projektion (d.h. senkrechte Verlängerung) einer Struktur auf eine Fläche, die parallel zur Ebene der Deckplatte ist. Senkrecht heißt hier senkrecht zur Ebene der Deckplatte. Die Ebene der Deckplatte ist die Ebene, in der sich die Deckplatte erstreckt.

Vorzugsweise weist die Deckplatte keine Krümmung auf und ist somit plan (eben). Die Deckplatte kann jedoch auch gekrümmt sein. Die Deckplatte kann starr oder biegsam sein. In Form einer biegsamen Deckplatte kann sie gleichsam in ebener Form bereitgestellt werden. Bei einer ebenen (planen) Deckplatte wird durch die Erstreckung der Deckplatte selbst eine Ebene definiert, welche im Sinne der Erfindung als "Ebene der Deckplatte" zu verstehen ist. Bei einer gekrümmten Deckplatte kann durch eine (gedachte) ebene Tangentialfläche an einem beliebigen Punkt der Ebene eine lokale Ebene definiert werden, welche ebenfalls unter den Begriff "Ebene der Deckplatte" fällt.

Die Maske kann mit dem Fachmann an sich bekannten Verfahren aufgebracht werden, beispielsweise Lithographie, Digitaldruck oder Siebdruck. Das Material der Maske ist wahlfrei, mit der Maßgabe, dass es von der Deckplatte ohne deren Beschädigung wieder entfernt werden kann. Als Maske kann beispielsweise eine Beschichtung verwendet werden, die eine Schichtdicke im Mikrometerbereich aufweist. Möglich ist auch, dass als Maske ein Klebeband eingesetzt wird.

Wie bereits ausgeführt, kann gemäß einer Alternative das Ausbilden des strukturierten Bereichs mit einer lichtstreuenden Struktur in der Außen- und/oder Innenfläche der Deckplatte zeitlich vor oder nach dem teilflächigen Ausbilden der (ersten) Interferenzschicht erfolgen, es sei denn die optische Interferenzschicht wird auf den strukturierten Bereich aufgebracht, was zwangsläufig die zeitliche Reihenfolge vorgibt, d.h. das Ausbilden des strukturierten Bereichs zeitlich vor dem Aufbringen der Maske.

Erfindungsgemäß kann somit in einfacher und kostengünstiger Weise durch Verwenden einer die Deckplattenfläche (Außen- und/oder Innenfläche) nur teilweise bedeckenden Maske eine transparente Deckplatte mit mindestens einer teilflächigen optischen Interferenzschicht hergestellt werden. Konkret weist die Deckplattenfläche in senkrechter Sicht durch die Deckplatte im ersten Bereich, der von der Maske nicht bedeckt war, die optische Interferenzschicht auf und weist im zweiten Bereich, der von der Maske bedeckt war, die optische Interferenzschicht nicht auf. Im Ergebnis führt die nur teilflächig aufgebrachte Interferenzschicht zu einer teilflächig unterschiedlichen Farbwirkung der Deckplatte bzw. Flächenkörper, entsprechend der Reflexion von Licht innerhalb eines vorgegebenen Wellenlängenbereichs. Genauer ergibt sich eine Gesamtfarbe durch eine Kombination der Farbe des Rückseitenelements und der Farbe des durch die mindestens eine optische Interferenzschicht reflektierten Lichts. Beispielsweise weisen bei CIGS-Dünnschichtsolarmodulen die fotovoltaisch aktiven Solarzellen eine bläulich-schwarze Färbung auf und tragen somit zur Gesamtfarbe des Flächenkörpers im Bereich der optischen Interferenzschicht bei. In dem von der (ersten) optischen Interferenzschicht nicht bedeckten zweiten Bereich der Fläche liegt eine solche Farbwirkung nicht vor, falls keine weitere optische Interferenzschicht vorgesehen ist (siehe unten). Hier ergibt sich die Farbe des Flächenkörpers im Wesentlichen durch die durch die Deckplatte sehbare Hintergrundfarbe (d.h. Farbe des Rückseitenelements). Vorteilhaft ist die Deckplatte zu diesem Zweck farbneutral. Es versteht sich, dass die Hintergrundfarbe des Rückseitenelements durch eine Tönung der transparenten Deckplatte auch verändert werden kann. Beispielsweise bei CIGS-Dünnschichtsolarmodulen ist in den Bereichen ohne optische Interferenzschicht die bläulich-schwarze Färbung der fotovoltaisch aktiven Solarzellen zu sehen. Bei CIGS-Dünnschichtsolarmodulen und generell bei Solarmodulen wird die Hintergrundfarbe durch die Farbe der Solarzellen bestimmt. Die Solarzellen erstrecken sich über den größten Teil der Deckplatte, beispielsweise mindestens 90%, insbesondere mindestens 95%. Bei einem passiven Flächenkörper ist das Rückseitenelement beispielsweise unbunt, dunkel und matt ausgebildet. Möglich ist auch, dass das Rückseitenelement farbig ist. Wie unten ausgeführt, kann die Deckplatte eine oder mehrerere weitere optische Inteferenzschichten aufweisen. In diesem Fall ergeben sich lokal unterschiedliche Farben, je nachdem ob nach Entfernen der Maske lokal (zweiter Bereich) nur die erste optische Interferenzschicht oder auch mindestens eine weitere optische Interferenzschicht vorhanden ist. Die teilflächig ausgebildete (erste) optische Interferenzschicht kann auf einer oder beiden Seiten der Deckplatte ausgebildet werden.

Gemäß einer vorteilhaften Ausgestaltung des erfindungsgemäßen Verfahrens wird nachdem teilflächigen Ausbilden der (ersten) optischen Interferenzschicht mindestens eine weitere (zweite) optische Interferenzschicht zur Reflexion von Licht innerhalb eines vorgegebenen bzw. vorgebbaren Wellenlängenbereichs auf die Deckplatte auf der gewählten Deckplattenseite aufgebracht wird, wobei die (zweite) optische Interferenzschicht in senkrechter Sicht durch die Deckplatte den ersten Bereich und den zweiten Bereich der Deckplattenfläche überdeckt. Die mindestens eine (zweite) optische Interferenzschicht wird somit insbesondere auf die bereits aufgebrachte (erste) optische Interferenzschicht aufgebracht. Vorzugsweise, jedoch nicht zwingend, wird die (zweite) optische Interferenzschicht direkt, d.h. ohne weitere Zwischenschicht, aufgebracht.

Gemäß einer weiteren vorteilhaften Ausgestaltung des erfindungsgemäßen Verfahrens wird eine transparente Deckplatte bereitgestellt, welche auf der gewählten Deckplattenseite und/oder der nicht gewählten Deckplattenseite jeweils mindestens eine weitere (dritte) optische Interferenzschicht zur Reflexion von Licht innerhalb eines vorgegebenen Wellenlängenbereichs aufweist, wobei die (dritte) optische Interferenzschicht in senkrechter Sicht durch die Deckplatte den ersten Bereich und den zweiten Bereich der Deckplattenfläche der gewählten Deckplattenseite überdeckt.

Gemäß der vorstehenden Ausgestaltungen des erfindungsgemäßen Verfahrens kann die Deckplatte mindestens eine zweite optische Interferenzschicht aufweisen, die sich (aus Sicht der Deckplatte) über der mindestens einen ersten optischen Interferenzschicht befindet (d.h. die mindestens eine erste optische Interferenzschicht ist zwischen der Deckplattenfläche und der mindestens einen zweiten optischen Interferenzschicht angeordnet). Alternativ oder ergänzend kann die Deckplatte mindestens eine dritte optische Interferenzschicht aufweisen, die sich (aus Sicht der Deckplatte) unter der mindestens einen ersten optischen Interferenzschicht befindet (d.h. die mindestens eine dritte optische Interferenzschicht ist zwischen der Deckplattenfläche und der mindestens einen ersten optischen Interferenzschicht angeordnet). Wesentlich hierbei ist, dass die mindestens eine weitere optische Inteferenzschicht (mindestens eine zweite optische Interferenzschicht und/oder mindestens eine dritte optische Interferenzschicht) in senkrechter Sicht durch die Deckplatte die mindestens eine (erste) teilflächige optische Interferenzschicht vollständig überdeckt und zudem in dem von der (ersten) teilflächigen optischen Interferenzschicht nicht überdeckten zweiten Bereich der Deckplattenfläche angeordnet ist. Somit sind die mindestens eine erste teilflächige optische Interferenzschicht und die mindestens eine zweite optische Interferenzschicht einander überlagert, wobei die mindestens eine zweite optische Interferenzschicht auch ohne Überlagerung mit der ersten teilflächigen optischen Interferenzschicht ausgebildet ist. Alternativ oder ergänzend sind die mindestens eine erste teilflächige optische Interferenzschicht und die mindestens eine dritte optische Interferenzschicht einander überlagert, wobei die mindestens eine dritte optische Interferenzschicht auch ohne Überlagerung mit der ersten teilflächigen optischen Interferenzschicht (aber gegebenenfalls in Überlagerung mit der mindestens einen zweiten optischen Interferenzschicht) ausgebildet ist.

Ergänzend kann eine Deckplatte bereitgestellt werden, die auf der nicht-gewählten Deckplattenseite mindestens eine dritte optische Interferenzschicht aufweist. Beispielsweise kann der Flächenkörper mindestens zwei frei wählbare Farben haben, nämlich eine erste Farbe, die sich im ersten Bereich der Fläche durch Reflexion von Licht an zwei übereinander liegenden optischen Interferenzschichten ergibt (erste und zweite optische Interferenzschicht), und eine zweite Farbe, die sich im zweiten Bereich der Fläche aus der Reflexion von Licht nur an der zweiten optischen Interferenzschicht ergibt. Der Farbeindruck ergibt sich jeweils aus einer Kombination der Farbe durch Reflexion an der/den optischen Interferenzschichten und der Farbe des Hintergrunds des Flächenkörpers. Vorteilhaft kann somit die Farbgebung der kompletten Deckplatte, also auch in Bereichen der Deckplatte, die zuvor durch die Maske bedeckt waren und keine optische Interferenzschicht aufweisen, durch mindestens eine optische Interferenzschicht gezielt zweifarbig gestaltet werden, wobei die beiden Farben frei wählbar sind.

Der Flächenkörper kann somit in einfacher Weise zweifarbig, insbesondere auch mehrfarbig, gestaltet werden, wobei sich eine Farbe durch eine oder mehrere einander überlagerte optische Interferenzschichten in Kombination mit der Hintergrundfarbe des Rückseitenelements und mindestens eine weitere Farbe durch die Hintergrundfarbe des Rückseitenelements ergibt. In besonders vorteilhafter Weise können somit beispielsweise ein farbiges Muster oder farbige Zeichen, die eine Information codieren, gegen einen andersfarbigen Hintergrund dargestellt werden.

Gemäß einer vorteilhaften Ausgestaltung der Erfindung kann das teilflächige Ausbilden der mindestens einen ersten optischen Interferenzschicht ein- oder mehrmalig wiederholt werden. Insbesondere kann die mindestens eine (erste) optische Interferenzschicht auf beiden Seiten der Deckplatte teilflächig ausgebildet werden. Möglich ist auch, dass die erste optische Interferenzschicht auf einer selben Seite der Deckplatte mehrmals ausgebildet wird. Bei einer Wiederholung werden die verschiedenen Schritte zur teilflächigen Ausbildung der ersten optischen Interferenzschicht in analoger Weise wie oben beschrieben durchgeführt.

Gemäß einer Ausgestaltung der Erfindung besteht die transparente Deckplatte aus einem einzigen Material, beispielsweise Glas oder Kunststoff, vorzugsweise Kalknatronglas. Vorzugsweise ist die Deckplatte eine starre Glas- oder Kunststoffplatte. Die Au-ßen- bzw. Innenfläche der Deckplatte wird in diesem Fall vom jeweiligen Material der Deckplatte gebildet. Gemäß einer alternativen Ausgestaltung besteht die Deckplatte aus mindestens zwei verschiedenen Materialien, wobei die Außen- und/oder Innenfläche der Deckplatte aus einem von einem Kern der Deckplatte verschiedenen Material gebildet wird. Der Kern der Deckplatte besteht vorzugsweise aus einem einzigen Material, beispielsweise Glas oder Kunststoff, vorzugsweise Kalknatronglas. Auf den Kern der Deckplatte ist außen- und/oder innenseitig ein vom Kern der Deckplatte verschiedenes Material angebracht, welches transparent ist und einen selben optischen Brechungsindex wie das Material des Kerns der Deckplatte hat. Die Außen- bzw. Innenfläche der Deckplatte wird in diesem Fall vom jeweiligen Material gebildet, das auf den Kern der Deckplatte aufgebracht ist. Erfindungsgemäß umfasst der Begriff "Deckplatte" somit auch Verbundkörper, mit der Maßgabe, dass die Materialien, welche die Deckplatte formen, transparent sind und einen gleichen optischen Brechungsindex haben.

Im Sinne vorliegender Erfindung bezieht sich der Begriff "Transparenz" bzw. "transparent" auf eine Durchlässigkeit für sichtbares Licht von wenigstens 80%, insbesondere wenigstens 90%, vorzugsweise wenigstens 95%, insbesondere 100%. Typischer Weise liegt sichtbares Licht im Wellenlängenbereich von 380 nm bis 780 nm vor. Der Begriff "Opazität" bzw. "opak" bezieht sich auf eine Durchlässigkeit für sichtbares Licht von weniger als 5%, insbesondere 0%. Die prozentualen Angaben beziehen sich auf die Intensität des Lichts, jeweils gemessen auf der einen Seite der Deckplatte, bezogen auf die Intensität des auf der anderen Seite der Deckplatte auftreffenden Lichts. Für eine solche Messung kann beispielsweise eine Weißlichtquelle (Quelle für sichtbares Licht) auf der einen Seite der Deckplatte und ein Detektor für sichtbares Licht auf der anderen Seite der Deckplatte angeordnet werden. Die nachfolgend genannten Werte für den optischen Brechungsindex beziehen sich immer auf den optischen Brechungsindex im sichtbaren Wellenlängenbereich von 380 nm bis 780 nm.

Die optischen Interferenzschichten können jeweils ein- oder mehrlagig ausgebildet sein, d.h. eine oder mehrere lichtbrechende Lagen (Brechungsschichten) aufweisen. Die optischen Interferenzschichten dienen eweils zur Erzeugung einer Farbe, wobei die optische Interferenzschichten jeweils so ausgebildet sind, dass eine konstruktive bzw. destruktive Interferenz von Licht, das an den verschiedenen Grenzflächen der optischen Interferenzschicht reflektiert wird, möglich ist. Die Farbe ergibt sich aus der Interferenz des an den Grenzflächen der optischen Interferenzschicht reflektierten Lichts. Bei Beleuchtung mit (Weiß-)Licht, insbesondere Sonnenlicht, wirkt die optische Interferenzschicht als Farbfilter zur Erzeugung einer homogenen Farbe.

Grundsätzlich können die optischen Interferenzschicht einen gleichen Brechungsindex und einen gleiche Schichtdicke aufweisen. Gemäß einer vorteilhaften Ausgestaltung des erfindungsgemäßen Verfahrens unterscheiden sich mindestens zwei optische Interferenzschichten in Brechungsindex und/oder Schichtdicke, wodurch eine Deckplatte mit einer Vielzahl von Farben erzeugbar ist.

Der Flächenkörper vermittelt dem Betrachter bei Beleuchtung von der Außenseite her mit weißem Licht, insbesondere bei Beleuchtung mit Sonnenlicht, einen aus mindestens zwei Farben bestehenden Farbeindruck, d.h. der Flächenkörper ist mehrfarbig. Vorzugsweise erstreckt sich der mehrfarbige Farbeindruck über die komplette Außenfläche des Flächenkörpers bzw. dessen Deckplatte.

Die Farbe des Flächenkörpers kann durch drei Farbkoordinaten L*, a*, b* beschrieben werden, wobei sich die Farbkoordinaten auf den dem Fachmann an sich bekannten (CIE)L*a*b*-Farbraum beziehen, in dem alle wahrnehmbaren Farben exakt definiert sind. Dieser Farbraum ist in der europäischen Norm EN ISO 11664-4 "Colorimetry - Part 4:CIE 1976 L*a*b* Colour space" spezifiziert, auf welche im Rahmen der vorliegenden Erfindungsbeschreibung vollumfänglich Bezug genommen wird. Im (CIE)L*a*b*-Farbraum ist jede Farbe durch einen Farbort mit den drei kartesischen Koordinaten L*, a*, b* definiert. Auf der a*-Achse liegen sich Grün und Rot gegenüber, die b*-Achse verläuft zwischen Blau und Gelb, die L*-Achse beschreibt die Helligkeit (Luminanz) der Farbe. Für eine anschaulichere Darstellung können die Größen in den Lhc-Farbraum umgerechnet werden, wobei L gleich bleibt und die Sättigung der Radius und h der Winkel eine Farbpunktes in der a*b*-Ebene ist.

Die Farben des Flächenkörpers beziehen sich auf eine Betrachtung von der äußeren Umgebung her, d.h. in Sicht auf die frontseitige Deckplatte. Die Farbmessung bzw. die Bestimmung der Farbkoordinaten des Flächenkörpers kann in einfacher Weise durch ein im Handel verfügbares Farbmessgerät (Spektralphotometer) erfolgen. Das Farbmessgerät wird zu diesem Zweck auf die Außenfläche der frontseitigen Deckplatte gerichtet, insbesondere auf die Außenfläche aufgesetzt. Übliche Farbmessgeräte ermöglichen eine normgerechte Farbmessung, wobei deren Aufbau und Toleranzen typischer Weise internationalen Normen unterliegen, beispielsweise definiert durch DIN 5033, ISO/CIE 10527, ISO 7724 und ASTM E1347. Beispielsweise wird hinsichtlich der Farbmessung auf die Norm DIN 5033 vollumfänglich Bezug genommen. Ein Farbmessgerät weist als Lichtquelle beispielsweise eine Xenon-Blitzlampe, Wolfram-Halogenlampe oder ein oder mehrere LEDs auf, wobei die Außenfläche eines Körpers mit dem erzeugten (z.B. Weiß-)Licht beleuchtet und das vom Flächenkörper empfangene Licht gemessen wird. Die die vom Farbmessgerät gemessene Körperfarbe ergibt sich aus dem reflektierten und remittierten Licht des Flächenkörpers.

Bei verschiedenen Ausgestaltungen des erfindungsgemäßen Verfahrens bzw. der Deckplatte weisen Außen- und/oder Innenfläche der Deckplatte jeweils einen strukturierten Bereich auf oder können mit einem solchen versehen werden. Die erste optische Interferenzschicht, sowie gegebenenfalls mindestens eine weitere (zweite und/oder dritte) optische Interferenzschicht können auf der Außen- und/oder Innenfläche angeordnet sein. Beispielsweise weist die Außenfläche einen strukturierten Bereich auf, die Innenfläche weist keinen strukturierten Bereich auf und mindestens eine optische Interferenzschicht wird teilflächig auf der Innenseite der Deckplatte ausgebildet. Optional wird mindestens eine weitere (zweite) optische Inteferenzschicht auf der Innenseite der Deckplatte ausgebildet (insbesondere auch über der ersten optischen Interferenzschicht). Optional weist die Deckplatte mindestens eine weitere (dritte) optische Inteferenzschicht auf der Innenseite der Deckplatte auf (insbesondere auch unter der ersten optischen Interferenzschicht).

Um zu erreichen, dass der Flächenkörper einen homogenen Farbeindruck hat, weist zumindest eine Oberfläche (d.h. Außenfläche und/oder Innenfläche) der Deckplatte einen strukturierten Bereich auf. Vorzugsweise erstreckt sich der strukturierte Bereich über die komplette Deckplattenfläche, d.h. über die komplette Außen- und/oder Innenfläche der Deckplatte, so dass das Flächenkörper insgesamt eine homogene Farbgebung hat.

Der Begriff "Strukturierung" bzw. "strukturierter Bereich" umfasst in besonders vorteilhaften Weise einen Bereich der Außen- und/oder Innenfläche der Deckplatte, in dem die nachstehend beschriebenen Merkmale in Kombination vorliegen.

Demnach weist der strukturierte Bereich senkrecht zur Ebene der Deckplatte ein Höhenprofil mit Bergen (Erhebungen) und Tälern (Einsenkungen) auf, wobei ein mittlerer Höhenunterschied zwischen den Bergen und Tälern mindestens 2 µm und vorzugsweise, jedoch nicht zwingend, maximal 20% einer Dicke der transparenten Deckplatte beträgt. Ferner setzen sich mindestens 50% des strukturierten Bereichs der Fläche (Außen- und/oder Innenfläche) aus unterschiedlich geneigten Segmenten bzw. Facetten (reflektierende Bereiche der Oberflächen) zusammen. Die Segmente sind Abschnitte der Oberfläche der Deckplatte und jeweils als plane Flächen ausgebildet, die zur Ebene der Deckplatte geneigt sind. Hierbei haben, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45°. Vorteilhaft, jedoch nicht zwingend haben weniger als 30% der Segmente einen Neigungswinkel von größer als 45°. Die Strukturen sind bevorzugt nicht periodisch und anisotrop. Für spezielle optische Effekte können jedoch auch periodische Strukturen und aniostrope Strukturen zur Anwendung kommen. Ferner sind die Segmente jeweils eben (plan) und haben eine Segmentfläche von mindestens 1 µm². Der strukturierte Bereich kann beispielsweise durch Ätzen, Sandstrahlen oder Walzen der Deckplatte hergestellt werden.

Der strukturierte Bereich weist eine Vielzahl von ebenen Segmenten auf. Im Sinne vorliegender Erfindung können ebene Segmente durch nicht-gekrümmte Flächen gebildet werden. Möglich ist aber auch, dass ebene Segmente durch geringfügig gekrümmte Flächen gebildet werden. Ein Segment ist im Sinne vorliegender Erfindung dann geringfügig gekrümmt, wenn für jeden Punkt des Segments gilt: wenn an einem Punkt des Segments eine (gedachte) Tangentialebene mit einer Fläche von 1 µm² konstruiert wird, beträgt der Abstand zwischen der Fläche des Segments und der Tangentialebene, bezogen auf die Normalenrichtung zur Tangentialebene, weniger als 50 nm.

Ferner gilt vorzugsweise, dass in mindestens einer Zone (d.h. Bereich) des strukturierten Bereichs die Segmente jeweils eine mittlere Rauigkeit von weniger als 15% der Schichtdicke der mindestens einen optischen Interferenzschicht haben. Falls die optische Interferenzschicht aus mehreren Brechungsschichten besteht, haben die Segmente der mindestens einen Zone jeweils eine mittlere Rauigkeit von weniger als 15% einer Schichtdicke der Brechungsschicht mit geringster Schichtdicke. Die Zone, in der die Segmente jeweils eine mittlere Rauigkeit von weniger als 15% der Schichtdicke der optischen Interferenzschicht haben, kann dem strukturierten Bereich entsprechen, d.h. Zone und strukturierter Bereich sind dann identisch.

Falls eine Fläche keine Strukturierung aufweist, ist diese glatt (im Rahmen der Produktionsungenauigkeiten).

Durch den strukturierten Bereich kann in vorteilhafter Weise erreicht werden, dass bei Beleuchtung der Deckplatte mit Licht auch bei einer Beobachtung außerhalb des Glanzwinkels (Einfallswinkel des auftreffenden Lichts entspricht Ausfallswinkel des reflektierten Lichts, bezogen auf die Ebene der Deckplatte) Licht mit relativ hoher Intensität zurückgeworfen wird. Ursache hierfür sind die verschieden geneigten Segmente, die in ausreichender Anzahl, geeigneter Größe und geeigneter Rauigkeit sowie geeigneten Neigungswinkeln vorhanden sind, um eine hohe Intensität des reflektierten Lichts auch bei einer Beobachtung außerhalb des Glanzwinkels zu ermöglichen. Es gibt stets hinreichend viele geneigte Segmente, die bei Strukturierung außen durch Reflexion oder Brechung an den Segmenten und bei Strukturierung innen durch Reflexion an den Segmenten genügend Intensität in Richtungen außerhalb des Glanzwinkels der Deckplatte streuen.

Wie hier und im Weiteren verwendet, bezieht sich der Begriff "Glanzwinkel" auf die Normale zur Ebene der Deckplatte, im Unterschied zum "lokalen Glanzwinkel", der sich auf die Normale zur Ebene eines Segments bezieht. Glanzwinkel und lokaler Glanzwinkel können gleich sein (Segment ist parallel zur Ebene der Deckplatte), sind jedoch in aller Regel verschieden (Segment ist geneigt zur Ebene der Deckplatte).

Im Ergebnis kann erreicht werden, dass die Intensität des nicht im Glanzwinkel reflektierten (d.h. gestreuten) Lichts relativ hoch ist und im Vergleich zu einer reflektierenden Oberfläche ohne einen solchen strukturierten Bereich, eine nur geringe Winkelabhängigkeit in Bezug auf die Einstrahl- und Beobachtungsrichtung hat. Mittels der optischen Interferenzschicht kann das außerhalb des Glanzwinkels reflektierte Licht, abhängig von Brechungsindex und Schichtdicke der mindestens einen optischen Interferenzschicht, einer Farbselektion unterzogen werden, so dass die Oberfläche der Deckplatte eine homogene Farbe mit relativ geringer Winkelabhängigkeit hat.

In dieser Hinsicht vorteilhaft weist der strukturierte Bereich ein Höhenprofil auf, bei dem ein mittlerer Höhenunterschied zwischen den Bergen und Tälern mindestens 2 µm, bevorzugt mindestens 10 µm und besonders bevorzugt mindestens 15 µm beträgt. Ein derart strukturierter Bereich kann durch Ätzen der Deckplatte (z.B. Deckglas) erzeugt werden. In dieser Hinsicht gleichermaßen vorteilhaft weist der strukturierte Bereich ein Höhenprofil auf, bei dem ein mittlerer Höhenunterschied zwischen den Bergen und Tälern mindestens 50 µm, bevorzugt mindestens 100 µm beträgt. Ein derart strukturierter Bereich kann durch Walzen der Deckplatte (z.B. Deckglas) erzeugt werden. Dementsprechend erstreckt sich die Erfindung vorteilhaft auf ein Fassadenelement, dessen mindestens ein strukturierter Bereich der Deckplatte durch Ätzen oder Walzen hergestellt ist, wodurch die genannten Höhenprofile herstellbar sind. Die Strukturen können aber auch durch das Aufbringen einer transparenten und strukturierten Schicht auf die Deckplatte erzeugt werden. Die Schicht muss dabei einen gleichen (oder zumindest sehr ähnlichen) Brechungsindex haben wie die Deckplatte. Erfindungsgemäß soll das Strukturieren einer Oberfläche der Deckplatte auch das Aufbringen einer solchen transparenten und strukturierten Schicht umfassen.

Die genannten Eigenschaften des strukturierten Bereichs der Deckplatte können durch herkömmliche Messgeräte, wie ein Mikroskop, insbesondere ein Konfokalmikroskop, oder ein Nadelprofilometter, bestimmt werden.

Vorzugsweise wird durch den strukturierten Bereich der Deckplatte erreicht, dass bei Beobachtungswinkeln von 45° und 15° (jeweils bezogen auf die Normale zur Ebene der Deckplatte) und einem Einfallswinkel, der um 45° (in beiden Richtungen) vom jeweiligen Glanzwinkel abweicht, eine Helligkeit L des reflektierten Lichts von mindestens 10 auftritt. Vorzugsweise tritt eine Helligkeit L des reflektierten Lichts von mindestens 15 und stärker bevorzugt mindestens 20 auf. Bei dieser Messung ist auf der von der zu charakterisierenden Seite abgewandten Seite der (unbeschichteten) Deckplatte eine schwarze Abdeckung angebracht. Für die Messung wird ein D65-Strahler verwendet und mit einem im Handel verfügbaren Mehrwinkel-Farbmessgerät die Helligkeit L gemessen (10° Öffnungswinkel). Der Messaufbau wird weiter unten näher erläutert. In diesem Zusammenhang wird auf die europäische Norm EN ISO 11664-4 in vollem Umfang Bezug genommen.

Bei einer vorteilhaften Ausgestaltung setzen sich mindestens 80%, besonders bevorzugt mindestens 90%, eines strukturierten Bereichs der Außenfläche oder der Innenfläche (je nachdem welche Fläche strukturiert ist) aus zur Ebene der Deckplatte geneigten Segmenten zusammen. Durch die Vergrößerung der Anzahl der Segmente kann die Intensität des vom strukturierten Bereich der Oberfläche der Deckplatte auch au-ßerhalb des Glanzwinkels reflektierten Lichts und dessen Winkelstabilität noch weiter gesteigert werden.

Bei einer weiteren vorteilhaften Ausgestaltung haben mindestens 30% der Segmente eines strukturierten Bereichs einen Neigungswinkel im Bereich von größer als 0° bis maximal 15°, mindestens 40% der Segmente einen Neigungswinkel im Bereich von größer als 15° bis maximal 45° und vorzugsweise, jedoch nicht zwingend, weniger als 10% der Segmente einen Neigungswinkel von größer als 45°. Besonders bevorzugt haben mindestens 40% der Segmente einen Neigungswinkel im Bereich von größer als 0° bis maximal 15°, mindestens 50% der Segmente einen Neigungswinkel im Bereich von größer als 15° bis maximal 45° und vorzugsweise, jedoch nicht zwingend, weniger als 10% der Segmente einen Neigungswinkel von größer als 45°. Falls relativ viele Facetten mit einem kleinen Neigungswinkel von weniger als 15° vorliegen, tritt (wie bei einer unstrukturierten Oberfläche) im Wesentlichen nur eine reflektierte Intensität bei einem Beobachtungswinkel nahe des Glanzwinkels auf, was erfindungsgemäß nicht erwünscht ist. Bei steileren Facetten verringert sich die Winkelabhängigkeit des reflektierten Lichts, jedoch können bei zahlreichen sehr steilen Facetten (größer als 45°) verstärkt Mehrfach-Reflexionen auftreten, was nachteilig ist, da dies in stärkerem Maße zur Einkopplung auch desjenigen Anteils des Lichtes in die Absorberschicht führen kann, dessen Reflexion erwünscht ist. Zudem ist es bei vielen Beschichtungsverfahren schwierig, eine konforme Bedeckung mit gleicher Schichtdicke gleichzeitig auf flachen und steilen Oberflächensegmenten zu gewährleisten. Die Schichtdicke der optischen Interferenzschicht einer auf den strukturierten Bereich aufgebrachten optischen Interferenzschicht würde also vom Neigungswinkel abhängen, was wiederum zu unerwünschten Winkelabhängigkeiten führt. In dieser Hinsicht am meisten bevorzugt ist eine Ausgestaltung, bei der die Segmente jeweils einen Neigungswinkel aufweisen, der größer als 0° ist und maximal 45° beträgt. Gemäß vorstehenden Bedingungen kann eine sehr hohe Intensität des reflektierten Lichts auch außerhalb des Glanzwinkels bei zugleich besonders geringer Winkelabhängigkeit der Intensität erreicht werden.

Die Strukturen sind bevorzugt nicht-periodisch und anisotrop. Für spezielle optische Effekte können jedoch auch periodische Strukturen und/oder anisotrope Strukturen zur Anwendung kommen. Periodische und anisotrope Strukturen wie Pyramiden, tetragonale oder hexagonale Wabenstrukturen oder Halbkugeln lassen sich gut mit Walzen beim Glasziehen herstellen. Sie können zu attraktiven Glanz und Farbeffekten verwendet werden. Wenn die Oberflächenstrukturen die oben genannten Bedingungen erfüllen, zeigen die Flächenkörper eine deutlich verringerte Abnahme der Farbigkeit für Winkel außerhalb der Glanzwinkel, jedoch sind die Winkelabhängigkeiten dann anisotrop in Bezug auf die Orientierung in der Ebene des Flächenkörpers.

Somit kann eine homogene Farbwirkung mit geringer Winkelabhängigkeit und gleichzeitig hohem Wirkungsgrad eines Flächenkörpers sehr zufriedenstellend gelöst werden. Einerseits wird durch die strukturierte Oberfläche der Deckplatte Licht mit einer hohen Intensität und geringer Winkelabhängigkeit auch außerhalb des Glanzwinkels reflektiert. Andererseits wird durch die Filterwirkung der mindestens einen optischen Interferenzschicht ermöglicht, dass Licht mit hoher Intensität absorbiert werden kann, so dass ein großer Anteil des auftreffenden Lichts mit hohem Wirkungsgrad bzw. möglichst geringem Wirkungsgradverlust verwertbar ist. Zudem wird durch die mindestens eine farbgebende optische Interferenzschicht ein guter homogener Farbeindruck erreicht, wobei in einfacher Weise durch Verwenden der Maskentechnik und selektives Anordnen der zuerst aufgebrachten (ersten) optischen Interferenzschicht zwei verschiedene Farben realisierbar sind. Die optische Interferenzschicht wirkt als Filter mit möglichst schmalbandiger Reflexion und einer breitbandigen Transmission.

Jede optische Interferenzschicht kann eine oder mehrere Brechungsschichten enthalten und insbesondere aus diesen bestehen. Eine Brechungsschicht besteht aus einem selben Material (mit gleicher Zusammensetzung) und weist insbesondere über die Schichtdicke hinweg einen homogenen (gleichen) Brechungsindex auf. Enthält eine optische Interferenzschicht mehrere Brechungsschichten, bestehen mindestens zwei Brechungsschichten aus einem voneinander verschiedenen Material und haben einen unterschiedlichen Brechungsindex. Vorteilhaft weist mindestens eine Brechungsschicht einen Brechungsindex n von größer als 1,7, vorzugsweise größer als 2,0 und besonders bevorzugt größer als 2,3 auf. Grundsätzlich gilt, dass je größer der Brechungsindex ist, desto geringer ist die Winkelabhängigkeit des reflektierten Lichts, so dass die Winkelabhängigkeit des Farbeindrucks weiter reduziert werden kann.

Vorteilhaft enthält die mindestens eine optische Interferenzschicht mindestens eine Verbindung, gewählt aus TiOₓ, ZrOₓ, SiC und Si₃N₄. Weist die optische Interferenzschicht zwei, drei oder mehr Lagen auf, enthält die optische Interferenzschicht vorzugsweise mindestens eine Verbindung, gewählt aus MgF2, Al₂O₃, SiO₂ und Siliziumoxinitrid. Dies sind Verbindungen mit einem relativ niedrigen Brechungsindex.

Aufgrund der Kombination einer strukturierten Oberfläche mit mindestens einer optischen Interferenzschicht, die nur eine geringe Anzahl an Brechungsschichten aufweist (z.B. ein bis drei Brechungsschichten) kann schon ein guter Farbeindruck erreicht werden. Durch die geringe Anzahl an Brechungsschichten wird die Herstellung vereinfacht und die Produktionskosten verringern sich.

Vorteilhaft enthält mindestens eine optische Interferenzschicht (insbesondere alle optischen Interferenzschichten) genau eine Brechungsschicht (oder besteht aus dieser), deren Brechungsindex n größer als 1,9, bevorzugt größer als 2,3, ist.

Gleichermaßen vorteilhaft enthält mindestens eine optische Interferenzschicht (insbesondere alle optischen Interferenzschichten) genau zwei Brechungsschichten (oder besteht aus diesen), wobei eine erste Brechungsschicht mit einen ersten Brechungsindex n1 auf der Deckplatte mit einem Brechungsindex nd vorliegt und eine zweite Brechungsschicht mit einem zweiten Brechungsindex n2 auf der ersten Brechungsschicht vorliegt. Für die Beträge (Absolutwerte) der Differenzen der Brechungsindizes gilt: |n1-nd| > 0,3 und |n2-n1| > 0,3 und mindestens einer der Brechungsindizes n1 oder n2 ist größer als 1,9, bevorzugt größer als 2,3.

Gleichermaßen vorteilhaft enthält mindestens eine optische Interferenzschicht (insbesondere alle optischen Interferenzschichten) genau drei Brechungsschichten (oder besteht aus diesen), wobei eine erste Brechungsschicht mit einen ersten Brechungsindex n1 auf der Deckplatte mit einem Brechungsindex nd vorliegt, eine zweite Brechungsschicht mit einem zweiten Brechungsindex n2 auf der ersten Brechungsschicht vorliegt und eine dritte Brechungsschicht mit einem dritten Brechungsindex n3 auf der zweiten Brechungsschicht vorliegt. Für die Beträge (Absolutwerte) der Differenzen der Brechungsindizes gilt: |n3-n2| > 0,3 und |n2-n1| > 0,3 und |n1-nd| > 0,3. Dabei verhalten sich die Werte der Brechungsindizes alternierend: entweder gilt n1 > n2 und n3 > n2 oder es gilt n1 < n2 und n3 < n2. Zudem ist mindestens einer der Brechungsindizes n1, n2 oder n3 größer als 1,9, bevorzugt größer als 2,3.

Durch eine optische Interferenzschicht mit genau einer, genau zwei oder genau drei Brechungsschichten kann bei vereinfachter Herstellung und geringeren Produktionskosten des Flächenkörpers ein homogener Farbeindruck des Flächenkörpers erzielt werden. Durch zwei- oder dreilagige Schichten kann die Farbkraft, d.h. Helligkeit und Sättigung, also die Reflexion in einem bestimmten engen Wellenbereich erhöht werden. Durch relativ hohe Brechungsindizes wird die Winkelabhängigkeit reduziert. Interferenzschichten aus Schichtstapeln mit mehr als drei Schichten in Kombination mit der strukturierten Deckplatte und den dargestellten Ausgestaltungen liegen ebenfalls im Bereich der Erfindung, sind aber komplexer in der Herstellung. Mit einer Vierfachschicht aus Brechschichten mit alternierend hohen und niedrigen Brechungsindizes kann beispielsweise die Bandbreite des reflektierten Lichts noch weiter reduziert werden bei verbesserter Transmission.

Im strukturierten Bereich der Deckplatte tritt eine Reflexion der einfallenden Lichtstrahlung auch außerhalb des Glanzwinkels mit relativ hoher Intensität auf. Der strukturierte Bereich ist zu diesem Zweck vorzugsweise so ausgebildet, dass ein Reflexions-Haze von mehr als 50%, besonders bevorzugt mehr als 90%, vorliegt. Der Reflexions-Haze lässt sich durch ein im Handel verfügbares Haze-Messgerät bestimmen. Nach ASTM D1003 ist Haze das Verhältnis aus diffusem Anteil des reflektierten Lichts zur Gesamtreflexion.

In der strukturierten Fläche ist mindestens eine Zone vorgesehen, in der die Segmente eine mittlere Rauigkeit von weniger als 15% der Schichtdicke der mindestens einen optischen Interferenzschicht haben, wodurch eine konstruktive bzw. destruktive Interferenz des reflektierten Lichts ermöglicht ist. Vorteilhaft erstreckt sich diese Zone über die gesamte Deckplatte. Gemäß einer Ausgestaltung weist der strukturierte Bereich mindestens eine weitere Zone, d.h. (Teil-)Bereich, auf, in dem die Segmente jeweils eine solche mittlere Rauigkeit aufweisen, dass eine Interferenz an der optischen Interferenzschicht nicht auftritt. Beispielsweise haben die Segmente dort eine mittlere Rauigkeit von 50% bis 100% der Schichtdicke der mindestens einen optischen Interferenzschicht. In diesen Zonen wird keine Farbe durch die optische Interferenzschicht erzeugt.

Die Erfindung erstreckt sich weiterhin auf ein Verfahren zum Herstellen eines Flächenkörpers, welches das erfindungsgemäße Verfahren zum Bearbeiten einer transparenten Deckplatte für einen Flächenkörper umfasst.

Die Erfindung erstreckt sich weiterhin auf eine transparente Deckplatte für einen Flächenkörper, die vorteilhaft, jedoch nicht zwingend, durch das oben beschriebene Verfahren hergestellt ist.

Die transparente Deckplatte weist eine Außenseite, die der äußeren Umgebung zugewandt sein soll, und eine gegenüberliegende Innenseite auf, wobei mindestens eine Deckplattenfläche, gewählt aus Außen- und Innenfläche, einen strukturierten Bereich mit einer lichtstreuenden Struktur aufweist. Mindestens eine (erste) optische Interferenzschicht zur Reflexion von Licht innerhalb eines vorgegebenen Wellenlängenbereichs ist auf einer Deckplattenseite, gewählt aus Außenseite und Innenseite, angeordnet. Hierbei ist die (erste) optische Interferenzschicht über einem ersten Bereich der Deckplattenfläche der Deckplattenseite angeordnet und über einem zweiten Bereich der Deckplattenfläche der Deckplattenseite nicht angeordnet, wobei der erste Bereich und der zweite Bereich in senkrechter Sicht durch die Deckplatte in Überdeckung zum strukturierten Bereich angeordnet sind.

Bei einer vorteilhaften Ausgestaltung des transparenten Deckplatte weist diese mindestens eine weitere (zweite und/oder dritte) optische Interferenzschicht auf der gewählten Deckplattenseite auf, wobei die (zweite und/oder dritte) optische Interferenzschicht in senkrechter Sicht durch die Deckplatte den ersten Bereich und den zweiten Bereich der Deckplattenfläche der gewählten Deckplattenseite überdeckt. Hierbei befindet sich mindestens eine weitere (zweite und/oder dritte) optische Interferenzschicht auf einer oder beiden Seiten der teilflächig aufgebrachten optischen Interferenzschicht.

Bei einer weiteren vorteilhaften Ausgestaltung des transparenten Deckplatte weist diese mindestens eine weitere (dritte) optische Interferenzschicht auf der nicht gewählten Deckplattenseite auf, wobei die (dritte) optische Interferenzschicht in senkrechter Sicht durch die Deckplatte den ersten Bereich und den zweiten Bereich der Deckplattenfläche der gewählten Deckplattenseite überdeckt.

Obige Ausführungen im Zusammenhang mit dem Verfahren zum Bearbeiten einer transparenten Deckplatte gelten gleichermaßen für die transparente Deckplatte selbst. Um unnnötige Wiederholungen zu vermeiden, wird auf dortige Ausführungen verwiesen.

Die Erfindung erstreckt sich weiterhin auf einen Flächenkörper, der eine erfindungsgemäße transparente Deckplatte aufweist. Der Flächenkörper ist insbesondere ein lichtabsorbierender Flächenkörper, wie ein Solarmodul zur fotovoltaischen Energieerzeugung oder ein Solarkollektor zur Energieumwandlung. Der lichtabsorbierende Flächenkörper kann beispielsweise als integrierter Bestandteil einer Gebäudehülle oder freistehenden Wand, beispielsweise als Fenster-, Fassaden- oder Dachelement, eingesetzt werden. Der Flächenkörper kann auch ein passiver Flächenkörper sein, der nur als integrierter Bestandteil einer Gebäudehülle oder freistehenden Wand dient.

Die Erfindung erstreckt sich weiterhin auf die Verwendung eines erfindungsgemäßen Flächenkörpers als integrierter Bestandteil einer Gebäudehülle oder freistehenden Wand, insbesondere als Fenster-, Fassaden- oder Dachelement. Der Flächenkörper kann ein aktiver oder passiver Flächenkörper sein. Der Flächenkörper ist geeignet und bestimmt als sichtbares flächiges Bauteil in die Gebäudehülle oder freistehende Wand, insbesondere in eine Fassade, eingebaut zu werden, wobei der Flächenkörper Teil einer Außenseite ist, die von der äußeren Umgebung her betrachtet werden kann. Der Flächenkörper kann als eigenständiger Bestandteil integriert werden, wobei die Außenfläche des Flächenkörpers Teil der Außenfläche der Gebäudehülle oder freistehenden Wand ist.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird im Weiteren näher erläutert, wobei Bezug auf die beigefügten Zeichnungen genommen wird. Es zeigen in vereinfachter, nicht maßstäblicher Darstellung:
- Fig. 1-4: den Grundaufbau verschiedener Ausgestaltungen des erfindungsgemäßen Flächenkörpers in schematischen Querschnittansichten;
- Fig. 5-6: schematische Querschnittansichten verschiedener Ausgestaltungen der Deckplatte des erfindungsgemäßen Flächenkörpers;
- Fig. 7: schematische Querschnittansichten bei der Herstellung der erfindungsgemäßen Deckplatte des erfindungsgemäßen Flächenkörpers;
- Fig. 8: ein Flussidiagramm zur Veranschaulichung der Verfahrensschritte, wie sie bei der Herstellung der Deckplatte gemäß Figur 7 durchgeführt werden;
- Fig. 9: eine Aufsicht auf einen Flächenkörper;
- Fig. 10: eine schematische Darstellung typischer Lichtverhältnisse an einem Flächenkörper;
- Fig. 11-14: schematische Darstellungen beispielhafter Lichtwege bei Reflexion im strukturierten Bereich;
- Fig. 15: eine schematische Darstellung der Interferenz von Lichtstrahlen in einer optischen Interferenzschicht;
- Fig. 16: eine Ausgestaltung der Deckplatte in einer schematischen Querschnittansicht;
- Fig. 17: eine schematische Darstellung beispielhafter Lichtwege bei Reflexion an der Deckplatte mit strukturierten Außenfläche in Kombination mit der innenseitigen Interferenzschicht gemäß der Ausgestaltung von Figur 6;
- Fig. 18: eine schematische Darstellung des Messverfahrens zur Mehrwinkel-Farbmessung.

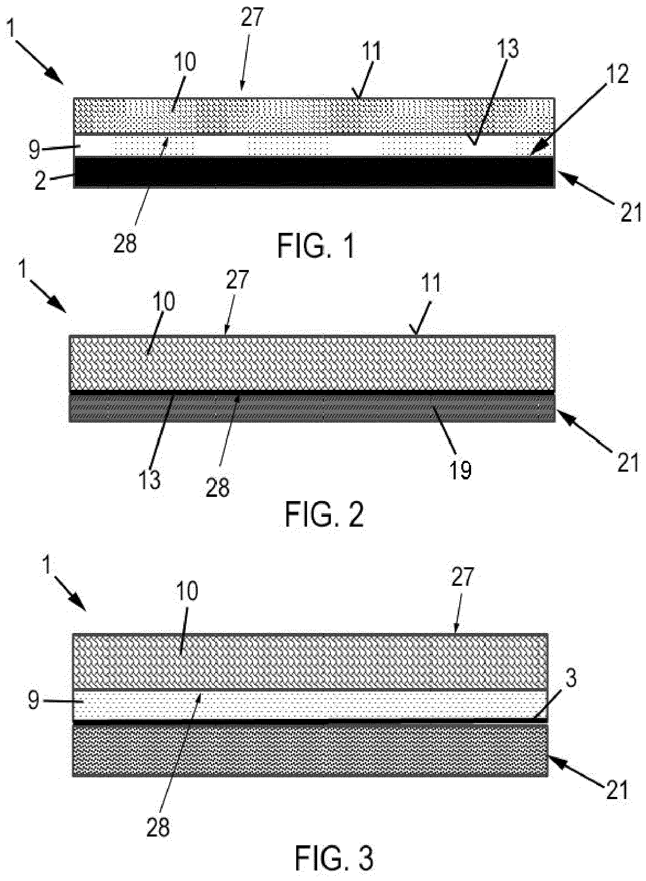

In Figur 1 ist ein insgesamt mit der Bezugszahl 1 bezeichneter Flächenkörper gemäß vorliegender Erfindung in schematischer Weise anhand einer Querschnittansicht veranschaulicht. Der Flächenkörper 1 ist hier beispielsweise in Form eines Solarmoduls mit Verbundscheibenstruktur ausgebildet. Die Schnittansicht ist senkrecht zur Moduloberfläche. Der Flächenkörper 1 umfasst eine Deckplatte 10 (z.B. Frontglas) und ein rückseitiges Substrat 2, die durch eine Klebeschicht 9 (z.B. Laminierungsfolie) fest miteinander verbunden sind. Auf dem Substrat 2 befinden sich Solarzellen 12 (Siliziumwafer- oder Dünnschichtsolarzellen). Das für den Flächenkörper 1 farbgebende Element ist die beschichtete Deckplatte 10, deren Außenfläche 11 gegen das einfallende Licht zeigt und deren Innenfläche 13 über die Klebeschicht 9 mit den Solarzellen 12 verbunden ist. Die Außenfläche 11 der Deckplatte 10 befindet sich auf deren Außenseite 27, die Innenfläche 13 auf deren Innenseite 28. Das Substrat 2 mit Solarzellen 12 bildet insgesamt ein opakes Rückseitenelement 21, dessen Eigenfarbe in wesentlicher Weise durch die Solarzellen 12 bestimmt ist. In den Randbereichen und zwischen den Solarzellen 12 können aber auch Kontaktierungsbänder und Randversiegelung oder bei Wafer-Solarzellen die Rückseitenfolie die Farbe bestimmen.

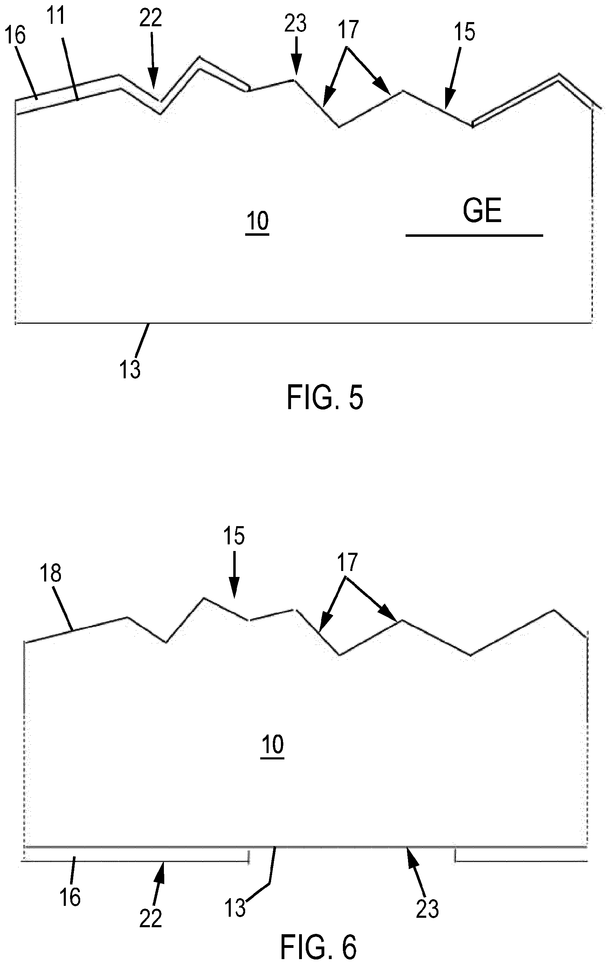

Die Deckplatte 10 ist hier eine Glasscheibe mit möglichst geringer Absorption und besteht zum Beispiel aus Kalknatronglas. Die Außenfläche 11 und/oder die Innenfläche 13 der Deckplatte 10 sind strukturiert (z.B. durch Ätzung, Sandstrahlen oder Walzen beim Ziehprozess) und zudem weisen Außenfläche 11 und/oder Innenfläche 13 mindestens eine optische Interferenzschicht auf, was in Figur 2 nicht dargestellt ist und weiter unten näher erläutert wird (siehe Figuren 5 und 6). Der ausgebildete Flächenkörper 1 kann als integrierter Bestandteil einer Gebäudehülle oder freistehenden Wand, insbesondere als Fassadenelement, eingesetzt werden.

In Figur 2 ist ein beispielhafter Aufbau eines passiven Flächenkörpers 1 gezeigt, der als integrierter Bestandteil einer Gebäudehülle oder freistehenden Wand, insbesondere als Fassadenelement, eingesetzt werden soll und lediglich eine bauliche Funktion erfüllt. Der Flächenkörper 1 umfasst eine transparente Deckplatte 10 und ein opakes Rückseitenelement 21. Die Deckplatte 10 ist wie in Figur 1 ausgebildet. Obige Ausführungen gelten analog. Möglich wäre auch, die Deckplatte 10 selbst als Verbundkörper auszubilden, wobei diese aus einem transparenten Kern besteht, der in ein anderes transparentes Material eingebettet ist (z.B. sandwichartig), welches den gleichen optischen Brechungsindex hat wie der Kern. Die Außenfläche 11 und Innenfläche 13 werden dann von diesem Material gebildet. Dies ist in Figur 2 nicht näher dargestellt. Das Rückseitenelement 21 ist hier beispielsweise in Form einer opaken Beschichtung 19 der Innenfläche 13 ausgebildet, welche sich über die komplette Innenfläche 13 erstreckt. Die Beschichtung 19 kann aus einer oder mehreren Schichten bestehen. Als Beschichtung können beispielsweise Lacke, Polymerschichten, Polymerfolien oder anorganische Schichten aus Metalloxidpulvern, Kohlenstoff oder Halbleitermaterialien eingesetzt werden. Die Schichtdicke des Rückseitenelements 21 ist frei wählbar, solange die gewünschten optischen Eigenschaften der Beschichtung gewährleistet sind. Falls erforderlich, kann das Rückseitenelement 21 durch eine rückseitige Abdeckung, die beispielsweise in Form einer weiteren Beschichtung oder Folie ausgebildet ist, vor Umwelteinwirkungen geschützt werden. Das Rückseitenelement 21 ist in seiner Ausgestaltung als Beschichtung nicht-tragend, so dass die Deckplatte 10 die spezifischen Anforderungen für die Nutzung als Fassadenelement zu erfüllen hat. Insbesondere sind die mechanische Belastbarkeit und die Möglichkeit einer geeigneten Verbindung mit dem Baukörper sicherzustellen, beispielsweise durch die Verwendung von Rahmen, Klammern oder Rückseitenschienen. Zu diesem Zweck besteht die Deckplatte 10 vorzugsweise aus veredeltem Glas, wie beispielsweise thermisch gehärtetes Glas, Einscheibensicherheitsglas(ESG), oder teilvorgespanntes Glas (TVG). Die Beschichtung ist opak und kann beispielsweise eine vorgebbare Farbe aufweisen, so dass durch die Hintergrundfarbe der Beschichtung in gewünschter Weise ein Gesamtfarbeindruck des Flächenkörpers 1 erzeugt wird. Es ist gleichermaßen möglich, dass das Rückseitenelement 21 zu diesem Zweck unbunt, dunkel und matt ist.

Figur 3 veranschaulicht eine Variante des passiven Flächenkörpers 1 von Figur 2. Demnach ist das Rückseitenelement 21 ein eigenständiger Körper mit definierter Raumform, der mit der Innenfläche 13 der Deckplatte 10 hier beispielsweise mittels einer transparenten Klebeschicht 9 (z.B. Laminierfolie) fest verbunden ist. Grundsätzlich kann jede geeignete Fügetechnik zur festen Verbindung von Deckplatte 10 und Rückseitenelement 21 eingesetzt werden, beispielsweise Kleben oder Vergießen. Vorteilhaft sind Fügeverfahren, bei denen das zum Fügen verwendete transparente Material (beispielsweise Klebeschicht, Laminierfolie oder Vergussmaterial) einen Brechungsindex von größer 1.4 und kleiner als 1.6 besitzt. Ansonsten kann gegebenenfalls die resultierende Farbe des Flächenkörpers 1 in unerwünschter Weise geändert werden. Beispielsweise ist das Rückseitenelement 21 in Form einer ebenen Platte ausgebildet, die mit der Deckplatte 10 einen Verbundkörper formt. Das Rückseitenelement 21 ist hierbei vorzugsweise tragend ausgebildet und weist zu diesem Zweck geeignete mechanische Eigenschaften auf, um durch sich selbst oder im Verbund mit der Deckplatte 10 die Tragfähigkeit des Flächenkörpers 1 sicherzustellen. Der so erzeugte Flächenkörper 1 kann als Fassadenelement in einfacher Weise mit einem Baukörper verbunden werden und muss insgesamt die Anforderungen als Fassadenelement in einer Gebäudehülle erfüllen. Das Rückseitenelement 21 besteht beispielsweise aus einem Faserverbundwerkstoff, Glas, Stein, Metall oder Keramik und kann insbesondere mit einer Farbe, beispielsweise eine keramische Siebdruckfarbe oder organische Glasfarbe oder einer geeigneten anorganischen Dünnschicht, beschichtet sein, um eine gewünschte Hintergrundfarbe bereitzustellen. Möglich ist auch, dass das Material des Rückseitenelements 21 selbst bereits eine gewünschte Farbe aufweist. Beispielsweise besteht das Rückseitenelement 21 aus einem in der Glasmatrix gefärbten Glas. Möglich ist auch die Verwendung von CIGS-Dünnschichten, die als Abfallprodukt aus der Serienproduktion von Dünnschichtsolarmodulen entstanden sind, um einen besonders homogenen Farbeindruck einer Fassade in Kombination mit als Fassadenelementen eingesetzten CIGS-Dünnschichtsolarmodulen zu erzielen. Der Schichtenaufbau 3 für die Solarzellen hat keine stromerzeugende Funktion. Ein gläsernes Rückseitenelement 21 kann in einfacher Weise mit herkömmlichen Laminierungsverfahren mit einer gläsernen Deckplatte 10 verbunden werden. Beispielsweise ist das Rückseitenelement 21 ein Metallblech, eine Metallfolie oder besteht aus einem Metallverbundmaterial. Das Metallblech oder die Metallfolie können beispielsweise durch Eloxieren oder Beschichten so behandelt werden, dass die gewünschten optischen Eigenschaften entstehen. Das Rückseitenelement 21 kann gleichermaßen aus für den Außenbereich geeigneten Baumaterialien bestehen, beispielsweise Faserzementplatten, Betonplatten, textilbewehrte oder faserverstärke Betonschalen, Holz/Holzfaserwerkstoffe, Kunststoffe oder andere nichtmetallische Verbundmaterialien. Die Oberfläche des Materials kann mit dem verwendeten Material entsprechenden Farbgebungstechnologien so gestaltet werden, dass sich die gewünschten optischen Eigenschaften ergeben. Die Deckplatte 10 ist wie in Figur 1 ausgebildet. Obige Ausführungen gelten analog.

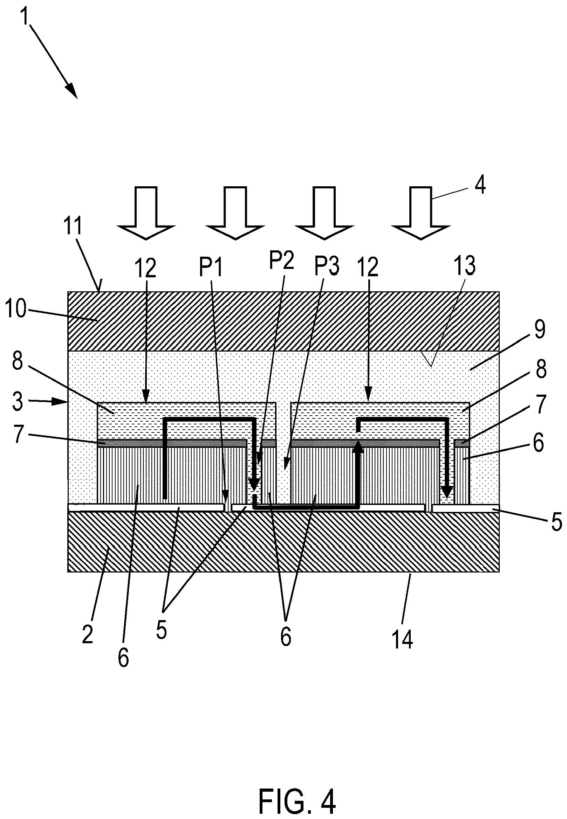

Unter Bezugnahme auf Figur 4 wird der beispielhafte Aufbau eines Dünnschichtsolarmoduls von Figur 1 näher erläutert. Der in Form eines Dünnschichtsolarmoduls ausgebildete Flächenkörper 1 umfasst eine Mehrzahl von in integrierter Form seriell miteinander verschalteten Solarzellen 12, von denen in stark vereinfachter Weise nur zwei dargestellt sind. Es versteht sich, dass im Flächenörper 1 in aller Regel eine Vielzahl von Solarzellen 12 (beispielsweise ca. 100-150) seriell verschaltet sind. Der Flächenkörper 1 weist eine Verbundscheibenstruktur in Substratkonfiguration auf. Es umfasst das rückseitige Substrat 2 mit einem darauf aufgebrachten Schichtenaufbau 3 aus dünnen Schichten, wobei der Schichtenaufbau 3 auf einer lichteintrittsseitigen Oberfläche des Substrats 2 angeordnet ist. Das Substrat 2 ist hier beispielsweise als starre, ebene Glasplatte mit einer relativ hohen Lichtdurchlässigkeit ausgebildet, wobei gleichermaßen andere elektrisch isolierende Materialien mit gewünschter Festigkeit und inertem Verhalten gegenüber den durchgeführten Prozessschritten eingesetzt werden können. Der Schichtenaufbau 3 umfasst eine auf der Oberfläche des Substrats 2 angeordnete opake Rückelektrodenschicht 5, die beispielsweise aus einem lichtundurchlässigen Metall wie Molybdän (Mo) besteht und durch Aufdampfen oder magnetfeldunterstützte Kathodenzerstäubung (Sputtern) auf das Substrat 2 aufgebracht wurde. Die Rückelektrodenschicht 5 hat beispielsweise eine Schichtdicke im Bereich von 300 nm bis 600 nm. Auf der Rückelektrodenschicht 5 ist eine fotovoltaisch aktive (opake) Absorberschicht 6 aufgebracht, die aus einem Halbleiter besteht, dessen Bandabstand in der Lage ist, einen möglichst großen Anteil des Sonnenlichts zu absorbieren. Die Absorberschicht 6 besteht beispielsweise aus einem p-leitenden Chalkopyrit-Halbleiter, beispielsweise eine Verbindung der Gruppe Cu(In/Ga)(S/Se)₂, insbesondere Natrium(Na)-dotiertes Cu(In/Ga)(S/Se)₂. In vorstehender Formel können Indium (In) und Gallium (Ga) sowie Schwefel (S) und Selen (Se) wahlweise oder in Kombination vorhanden sein. Die Absorberschicht 6 hat eine Schichtdicke, die beispielsweise im Bereich von 1-5 µm liegt und insbesondere ca. 2 µm beträgt. Für die Herstellung der Absorberschicht 6 werden typischer Weise verschiedene Materiallagen beispielsweise durch Sputtern aufgebracht, die anschließend durch Erwärmen in einem Ofen, gegebenenfalls in einer S- und/oder Se-haltigen Atmosphäre, zum Verbindungshalbleiter thermisch umgesetzt werden (RTP = Rapid Thermal Processing). Dem Fachmann ist diese Art der Herstellung eines Verbindungshalbleiters wohlbekannt, so dass hier nicht näher darauf eingegangen werden muss. Auf die Absorberschicht 6 ist eine Pufferschicht 7 abgeschieden, die hier beispielsweise aus einer Einzellage Cadmiumsulfid (CdS), Indiumsulfid (InₓS_{y}) oder Zinkoxysulfid (ZnOS) und optional einer Einzellage aus intrinsischem Zinkoxid (i-ZnO) oder Zinkmagnesiumoxid (ZnMgO) besteht, was in Figur 1 nicht näher dargestellt ist. Auf die Pufferschicht 7 ist eine Frontelektrodenschicht 8 beispielsweise durch Sputtern aufgebracht. Die Frontelektrodenschicht 8 ist für Strahlung im sichtbaren Spektralbereich transparent ("Fensterelektrode"), so dass das einstrahlende Sonnenlicht 4 (in Fig. 1 durch Pfeile veranschaulicht) nur gering geschwächt wird. Die Frontelektrodenschicht 8 basiert beispielsweise auf einem dotierten Metalloxid, beispielsweise n-leitendes Aluminium (Al)-dotiertes Zinkoxid (ZnO). Eine solche Frontelektrodenschicht 8 wird allgemein als TCO-Schicht (TCO = Transparent Conductive Oxide) bezeichnet. Die Schichtdicke der Frontelektrodenschicht 8 beträgt beispielsweise ca. 1000 nm. Durch die Frontelektrodenschicht 8 wird gemeinsam mit der Pufferschicht 7 und der Absorberschicht 6 ein Heteroübergang (d.h. Abfolge von Schichten vom entgegen gesetzten Leitungstyp) gebildet. Dabei kann die Pufferschicht 7 eine elektronische Anpassung zwischen der Absorberschicht 6 und der Frontelektrodenschicht 8 bewirken. Zum Schutz vor Umwelteinflüssen ist auf dem Schichtenaufbau 3 die (Kunststoff-)Klebeschicht 9 aufgebracht, die zur Verkapselung des Schichtenaufbaus 3 dient. Verklebt mit der Klebeschicht 9 ist die für Sonnenlicht transparente front- bzw. lichteintrittsseitige Deckplatte 10, die hier beispielsweise in Form einer starren (ebenen) Glasplatte aus extraweißem Glas mit geringem Eisengehalt ausgebildet ist. Die Deckplatte 10 dient zur Versiegelung und für einen mechanischen Schutz des Schichtenaufbaus 3. Die Deckplatte 10 verfügt über die den Solarzellen 12 zugewandte Innenfläche 13 und die von den Solarzellen 12 abgewandte Außenfläche 11, welche gleichzeitig die Moduloberfläche bzw. Moduloberseite ist. Über die Außenfläche 11 kann das Dünnschichtsolarmodul Sonnenlicht 4 aufnehmen, um an resultierenden Spannungsanschlüssen (+,-) eine elektrische Spannung zu erzeugen. Ein Strompfad ist in Fig. 4 durch seriell angeordnete Pfeile veranschaulicht. Die Deckplatte 10 und das Substrat 2 sind durch die Klebeschicht 9 fest miteinander verbunden ("laminiert"), wobei die Klebeschicht 9 hier beispielsweise als thermoplastische Klebeschicht ausgebildet ist, die durch Erwärmen plastisch verformbar wird und beim Abkühlen die Deckplatte 10 und das Substrat 2 fest miteinander verbindet. Die Klebeschicht 9 kann im Herstellungsprozess als Laminierfolie bereitgestellt werden und besteht hier beispielsweise aus PVB. Die Deckplatte 10 und das Substrat 2 mit den in die Klebeschicht 9 eingebetteten Solarzellen 12 formen gemeinsam einen laminierten Verbund. Die Modulrückseite 14 ist durch die den Solarzellen 12 abgewandte Oberfläche des Substrats 2 gegeben.

Für die Ausbildung und die Serienverschaltung der Solarzellen 12 ist der Schichtenaufbau 3 unter Einsatz einer geeigneten Strukturierungstechnologie, beispielsweise Laserschreiben und/oder mechanische Abtragung, strukturiert. Es ist gängig zu diesem Zweck unmittelbare Abfolgen von jeweils drei Strukturierungslinien P1-P2-P3 in den Schichtenaufbau 3 einzubringen. Hierbei wird durch erste Strukturierungslinien P1 mindestens die Rückelektrodenschicht 5 unterteilt, wodurch die Rückelektroden der Solarzellen 12 erzeugt werden. Durch zweite Strukturierungslinien P2 wird mindestens die Absorberschicht 6 unterteilt, wodurch die fotovoltaisch aktiven Bereiche (Absorber) der Solarzellen 12 erzeugt werden. Durch dritte Strukturierungslinien P3 wird mindestens die Frontelektrodenschicht 8 unterteilt, wodurch die Frontelektroden der Solarzellen 12 erzeugt werden. Mittels der zweiten Strukturierungslinie P2 ist die Frontelektrode einer Solarzelle 12 mit der Rückelektrode einer angrenzenden Solarzelle 12 elektrisch verbunden, wobei die Frontelektrode die Rückelektrode beispielsweise direkt kontaktiert. In dem Ausführungsbeispiel von Figur 4 sind die Gräben der ersten Strukturierungslinien P1 durch Material der Absorberschicht 6 verfüllt. Die Gräben der zweiten Strukturierungslinien P2 sind durch Material der Frontelektrodenschicht 8 verfüllt und die Gräben der dritten Strukturierungslinien P3 sind durch die Klebeschicht 9 verfüllt. Jede unmittelbare Abfolge aus erster, zweiter und dritter Strukturierungslinie P1-P2-P3 bildet eine Strukturierungszone zur Serienverschaltung zweier unmittelbar benachbarter Solarzellen 12. Die Erfindung erstreckt umfasst aber auch Solarmodule auf Basis von Silizum-Waferzellen und jede andere Technologie zur Herstellung von Solarzellen.

In Figur 5 ist anhand eines vergrößerten Ausschnitts eine beispielhafte Ausgestaltung der Deckplatte 10 des in den Figuren 1 bis 4 veranschaulichten Flächenkörpers 1 gezeigt. Die Außenfläche 11 der Deckplatte 10 ist in einem Bereich 15 strukturiert, welcher sich im vorliegenden Beispiel über die komplette Außenfläche 11 erstreckt, d.h. Außenfläche 11 und strukturierter Bereich 15 sind identisch. Die Innenfläche 13 ist nicht strukturiert. Unmittelbar auf der Außenfläche 11 ist eine erste optische Interferenzschicht 16 teilflächig angeordnet. Im strukturierten Bereich 15 ist die Außenfläche 11 mit einem Höhenprofil versehen, das Berge und Täler aufweist. Hierbei bestehen mehr als 50% der Außenfläche 11 aus ebenen Segmenten 17, deren Ebenen jeweils zur Ebene der Deckplatte 10 geneigt sind, d.h. einen von Null verschiedenen Winkel aufweisen. Ein mittlerer Höhenunterschicht zwischen den höchsten Punkten (Berge) und niedrigsten Punkten (Täler) der Außenfläche 11 beträgt mindestens 5 µm und beispielsweise maximal 20% der Dicke der transparenten Deckplatte 10. Bezogen auf die Ebene der Deckplatte 10 haben mindestens 20% der Segmente 17 einen Neigungswinkel im Bereich von größer als 0° bis maximal 15°, mindestens 30% der Segmente einen Neigungswinkel im Bereich von größer als 15° bis maximal 45° und weniger als 30% der Segmente 17 einen Neigungswinkel von größer als 45°. Im Ausführungsbeispiel von Figur 3 haben alle Segmente einen Neigungswinkel von maximal 45°.

Die erste optische Interferenzschicht 16 ist dünn und weist eine Schichtdicke beispielsweise im Bereich von 0,1 bis einigen (z.B. 5) Mikrometer auf. Ferner hat die erste optische Interferenzschicht 16 einen Brechungsindex n von größer als 1,7, vorzugsweise größer als 2,0 und besonders bevorzugt größer als 2,3, sowie eine möglichst geringe Absorption in Bezug auf das einfallende Licht. Die erste optische Interferenzschicht 16 kann ein- oder mehrlagig ausgebildet sein, d.h. aus einer oder mehreren Brechungsschichten bestehen. Jede Brechungsschicht weist einen bestimmten Brechungsindex auf und besteht aus demselben Material. Beispielsweise besteht die optische Interferenzschicht 16 aus MgO, SiONx, Si₃N₄, ZrO₂, TiOx und/oder SiC. Die elektrische Leitfähigkeit der einzelnen Brechungsschichten, insbesondere der ersten optischen Interferenzschicht 16, sollte möglichst gering sein. Die erste optische Interferenzschicht 16 bedeckt die Außenfläche 11 nicht vollständig, sondern nur teilflächig. Konkret setzt sich die Außenfläche 11 aus einem von der ersten optischen Inteferenzschichtschicht 16 bedeckten ersten Bereich 22 und einem von der ersten optischen Interferenzschicht 16 nicht bedeckten zweiten Bereich 23 zusammen. Die erste optische Inteferenzschicht 16 kann sich insbesondere über die komplette Außenfläche 11 erstrecken und diese vollständig bedecken, mit Ausnahme des zweiten Bereichs 23.

Der zweite Bereich 23 und der erste Bereich 22 befinden sich in senkrechter Sicht durch die Deckplatte 10 jeweils in Überlapp (Überdeckung) mit dem strukturierten Bereich 15. Dies bedeutet, dass sich bei einer senkrechten Projektion (senkrechte Verlängerung) des strukturierten Bereichs 15 auf eine (gedachte) Fläche, welche parallel zur Ebene GE der Deckplatte 10 ist, und bei einer senkrechten Projektion (senkrechte Verlängerung) des zweiten Bereichs 23 bzw. des ersten Bereichs 22 auf dieselbe Fläche der Deckplatte 10, der erste Bereich 23 sowie der zweite Bereich 22 in Überlapp mit und vorteilhaft innerhalb des strukturierten Bereichs 15 befinden. Die zur Ebene GE parallele Fläche ist beispielsweise die Innenfläche 13.

In Figur 5 ist die Ebene GE der Deckplatte 10 beispielhaft eingezeichnet. Die Ebene GE ergibt sich aus der im Wesentlichen planen Form der Deckplatte 10. Die eingezeichnete Ebene E ist lediglich beispielhaft und kann auch eine andere Position haben. Im vorliegenden Beispiel, bei dem die Innenfläche 13 nicht strukturiert ist, ist die Ebene E parallel zur Innenfläche 13. In Bezug auf die strukturierte Außenfläche 11 ist die Ebene E parallel zu einer durch Mittelung der Segmente 17 erzeugten gedanklichen Fläche der Außenfläche 11.

In dem von der ersten optischen Interferenzschicht 16 bedeckten ersten Bereich 22 der Außenfläche 11 tritt eine gefilterte Reflexion von Lichtstrahlen innerhalb eines vorgegebenen bzw. vorgebbaren Wellenlängenbereichs auf, was weiter unten noch näher erläutert wird. In dem von der ersten optischen Interferenzschicht 16 nicht bedeckten Bereich 23 der Außenfläche 11 erfolgt im Wesentlichen keine solche gefilterte Reflexion. Eine Farbwirkung durch die optische Interferenzschicht 16 liegt deshalb nur im ersten Bereich 22 der Außenfläche 11 vor. In jedem Fall gibt es einen Kontrast.

In Figur 6 ist eine Variante der Deckplatte 10 von Figur 5 veranschaulicht. Um unnötige Wiederholungen zu vermeiden, werden nur die Unterschiede zu Figur 5 erläutert und ansonsten wird auf die Ausführungen zu Figur 5 Bezug genommen. Demnach befindet sich die erste optische Interferenzschicht 16 nicht auf der Außenfläche 11 der Deckplatte 10, sondern nur auf der nicht-strukturierten Innenfläche 13 der Deckplatte 10. Analog zu Figur 5 weist die Innenfläche 13 einen von der ersten optischen Interferenzschicht 16 bedeckten ersten Bereich 22 und einen von der ersten optischen Interferenzschicht 16 nicht bedeckten zweiten Bereich 23 auf.

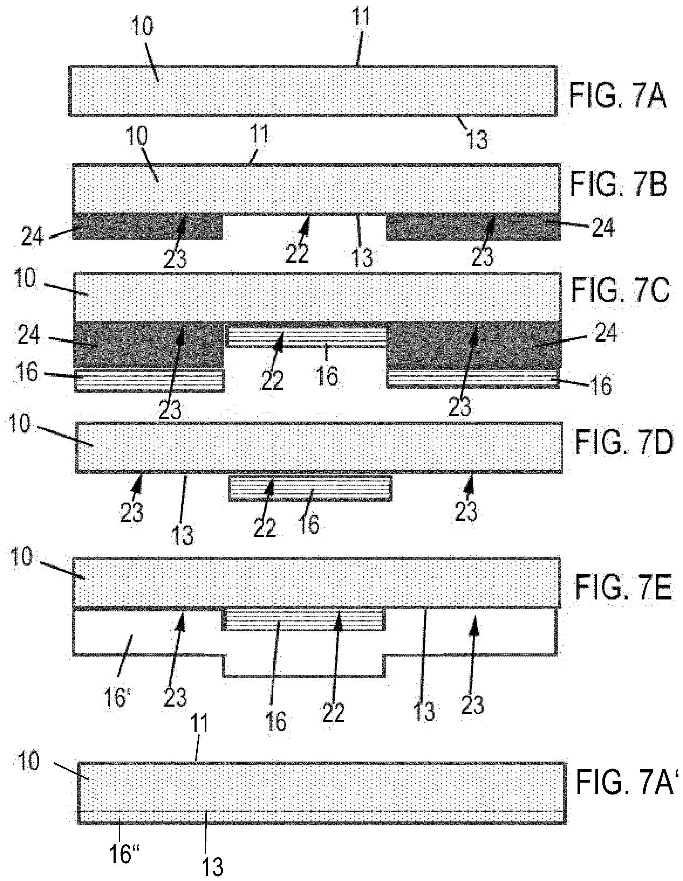

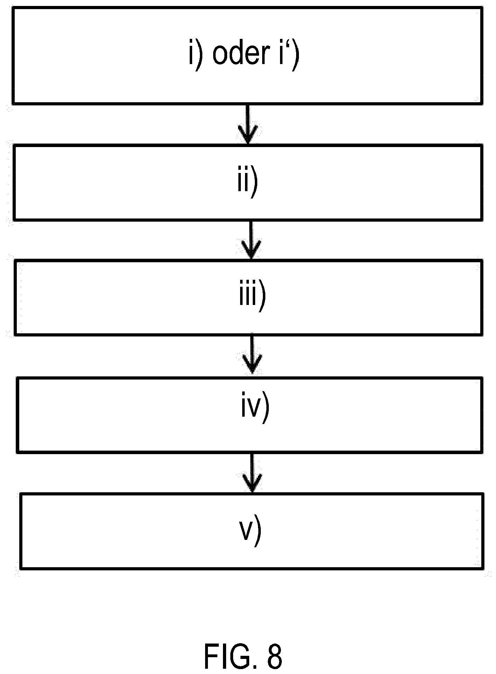

Es werden nun die Figuren 7A-7E betrachtet, worin anhand schematischer Querschnittansichten eine beispielhafte Herstellung der Deckplatte 10 von Figur 6 veranschaulicht ist. Demnach ist die Außenfläche 11 strukturiert und die Innenfläche 13 ist nicht strukturiert. Die optische Interferenzschicht 16 ist nur auf der Innenfläche 13 aufgebracht. Es sind jeweils die Zwischenstufen der Deckplatte 10 bei deren Herstellung veranschaulicht. Der zeichnerischen Einfachheit halber ist die Strukturierung der Außenfläche 11 weggelassen. In Figur 8 ist ergänzend ein Flussdiagramm für die hierbei durchgeführten sukzessiven Verfahrensschritte dargestellt.

### Schritt i):

Gemäß einer ersten Alternative wird eine transparente Deckplatte 10 (Frontglas) bereitgestellt, welche auf der Außenfläche 11 bereits einen strukturierten Bereich 15 aufweist (Figur 7A).

### Schritt i'):

Gemäß einer zweiten Alternative wird eine nicht-strukturierte transparente Deckplatte 10 bereitgestellt, die erst nach Bereitstellung mit einem strukturierten Bereich 15 versehen wird. Das Verfahren umfasst also das Bereitstellen einer nicht-strukturierten transparenten Deckplatte 10 mit einer Außenfläche 11, welche einer äußeren Umgebung zugewandt sein soll, und einer gegenüberliegenden Innenfläche 13, sowie das Ausbilden eines strukturierten Bereichs 15 mit einer lichtstreuenden Struktur in mindestens einer Fläche, gewählt aus Außen- und Innenfläche (Figur 7A).

Das Ausbilden des strukturierten Bereichs 15 kann im vorliegenden Fall zu einem beliebigen Zeitpunkt erfolgen, da sich die erste optische Interferenzschicht 16 und der strukturierte Bereich 15 auf verschiedenen Oberflächen der Deckplatte 10 befinden. Bei der Variante von Figur 5 wäre es erforderlich, dass der strukturierte Bereich 15 bereits vor dem Aufbringen der Maske 24 ausgebildet wird.

Es versteht sich, dass eine Deckplatte 10, die bereits einen strukturierten Bereich 15 aufweist, nach Bereitstellen nochmals mit einem strukturierten Bereich 15 versehen werden kann. In der ersten Alternative gemäß Schritt i) kann optional das Ausbilden eines strukturierten Bereichs 15 mit einer lichtstreuenden Struktur in mindestens einer Fläche, gewählt aus Außen- und Innenfläche, vorgesehen sein.

### Schritt ii):

Anschließend wird eine Maske 24 auf die Innenfläche 13 der Deckplatte 10 teilflächig aufgebracht. Die Maske 24 bedeckt einen ersten Bereich 22 der Innenfläche 13 nicht, aber bedeckt einen zweiten Bereich 23 der Innenfläche 13. Der zweite Bereich 23, vorzugsweis der komplette zweite Bereich 23, weist in senkrechter Sicht durch die Deckplatte 10 einen Überlapp mit dem strukturierten Bereich 15 auf (Figur 7B).

### Schritt iii):

Anschließend wird eine (erste) optische Interferenzschicht 16 zur Reflexion von Licht innerhalb eines vorgegebenen Wellenlängenbereichs auf die mit der Maske 24 teilflächig bedeckte Innenfläche 13 aufgebracht. Die optische Interferenzschicht 16 wird auf die Maske 24 und mindestens teilweise auf den von der Maske 24 nicht bedeckten ersten Bereich 22 der Innenfläche 13 aufgebracht (Figur 7C).

### Schritt iv):

Anschließend wird die Maske 24 entfernt, wobei die auf die Maske 24 aufgebrachte optische Interferenzschicht 16 mitentfernt wird (Figur 7D).

Durch die obigen Schritte i) bis iv) kann eine Deckplatte 10 mit der Konfiguration von Figur 6 hergestellt werden.

Gemäß einer besonders bevorzugten Ausgestaltung des Verfahrens wird optional ein weiterer Schritt v) durchgeführt:

### Schritt v)

Hierbei wird mindestens eine weitere optische Interferenzschicht 16' zur Reflexion von Licht innerhalb eines vorgegebenen Wellenlängenbereichs auf den zweiten Bereich 23 der Innenfläche 13 und mindestens teilweise, insbesondere vollständig, auf die bereits aufgebrachte optische Interferenzschicht 16 aufgebracht. Die hierbei ausgebildete Deckplatte 10 ist in Figur 7E veranschaulicht.

Die nur teilflächig im ersten Bereich 22 aufgebrachte erste optische Interferenzschicht 16 führt zu einer lokalen Farbwirkung der Deckplatte 10, entsprechend der Reflexion von Licht innerhalb eines vorgegebenen Wellenlängenbereichs der optischen Interferenzschicht 16. Im verbauten Zustand der Deckplatte 10 ergibt sich die Farbe des Flächenkörpers 1 im ersten Bereich 22 durch eine Kombination der durch die erste optische Reflexionsschicht 16 bedingten Farbe und der Hintergrundfarbe des Rückseitenelements 21.

In den Ausgestaltungen der Figuren 5 und 6 befindet sich im zweiten Bereich 23 keine erste optische Interferenzschicht 16. Im verbauten Zustand der Deckplatte 10 ergibt sich im zweiten Bereich 23 die lokale Farbwirkung im Wesentlichen durch die Hintergrundfarbe des Rückseitenelements 21, dessen Farbe durch die transparente Deckplatte 10 hindurch erkennbar ist.

In der Ausgestaltung von Figur 7E befindet sich im zweiten Bereich 23 die weitere (zweite) optische Interferenzschicht 16'. Im ersten Bereich 22 sind die beiden optischen Interferenzschichten 16, 16' überlagert. Im verbauten Zustand der Deckplatte 10 ergibt sich die Farbe des Flächenkörpers 1 im zweiten Bereich 23 durch eine Kombination der durch die optische Reflexionsschicht 16' bedingten Farbe und der Hintergrundfarbe des Rückseitenelements 21. Im ersten Bereich 22 ergibt sich die Farbe durch eine Kombination der durch die beiden übereinander liegenden optischen Reflexionsschichten 16, 16' bedingten Farbe und der Hintergrundfarbe des Rückseitenelements 21.

Wie in Figur 7A' veranschaulicht, kann die bereitgestellte Deckplatte 10 mindestens eine weitere (dritte) optische Interferenzschicht 16" aufweisen, die insbesondere vollflächig auf die Außenfläche 11 und/oder Innenfläche 13 aufgebracht sein kann. Die dritte optische Interferenzschicht 16" ist auf den ersten Bereich 22 und den zweiten Bereich 23 der Innenfläche 13 aufgebracht. Die dritte optische Interferenzschicht 16" kann alternativ oder ergänzend zur zweiten optischen optische Interferenzschicht 16' vorgesehen sein.

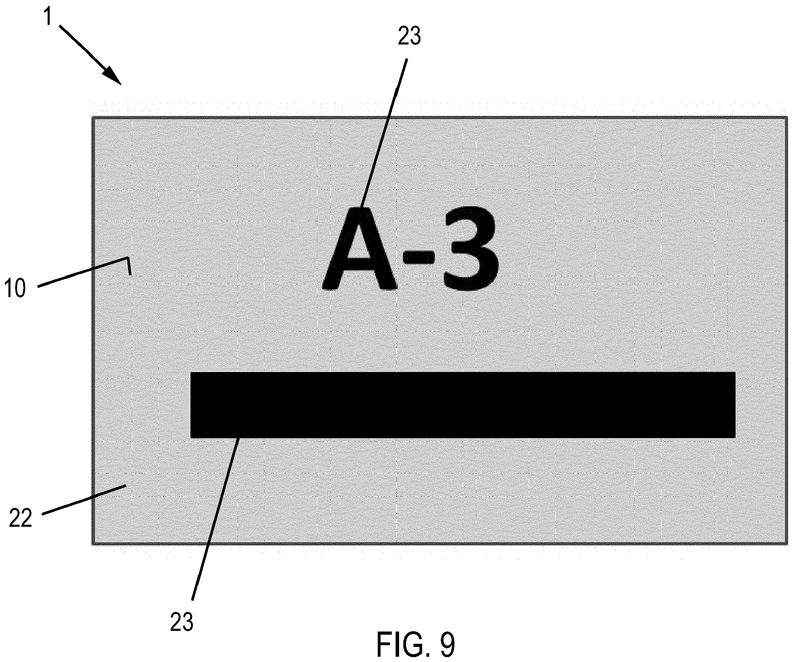

Wie in Figur 9 anhand einer Aufsicht auf den Flächenkörper 1 mit Deckplatte 10 veranschaulicht ist, kann bei allen Ausgestaltungen die Oberfläche des Flächenkörpers 1 zwei Farben haben. Hierdurch können Muster (hier: Balken) oder Zeichen (hier: "A-3"), die Informationen kodieren, insbesondere Text, gegen einen andersfarbigen Hintergrund abgesetzt werden. Der Betrachter blickt in Figur 9 von oben auf die Deckplatte 10.

Bei den Ausgestaltungen der Deckplatte 10 der Figuren 5 und 6 ergibt sich eine erste Farbe im ersten Bereich 22 durch eine Kombination der Farbwirkung der optischen Interferenzschicht 16 und der Hintergrundfarbe des Rückseitenelements 21 und eine zweite Farbe im zweiten Bereich 23 ergibt sich durch die Hintergrundfarbe des Rückseitenelements 21. Die Farbe im ersten Bereich 22 ist frei wählbar. Bei der Ausgestaltung der Deckplatte 10 der Figur 7E ergibt sich eine erste Farbe im ersten Bereich 22 durch eine Kombination der Farbwirkung der beiden optischen Interferenzschichten 16, 16' und der Hintergrundfarbe des Rückseitenelements 21 und eine zweite Farbe im zweiten Bereich 23 ergibt sich durch eine Kombination der Farbwirkung der später aufgebrachten optischen Interferenzschicht 16' und der Hintergrundfarbe des Rückseitenelements 21. Sowohl die erste Farbe im ersten Bereich 22 als auch die zweite Farbe im zweiten Bereich 23 sind innerhalb eines großen Farbraums wählbar im Rahmen der physikalsichen Freiheitsgrade (Schichtdicken, Brechungsindizes). In Figur 9 entsprechen die Muster und Zeichen dem zweiten Bereich 23 und der andersfarbige Hintergrund dem ersten Bereich 22, wobei es aber gleichermaßen möglich wäre, dass die Muster und Zeichen dem ersten Bereich 22 und der andersfarbige Hintergrund dem zweiten Bereich 23 entsprechen.

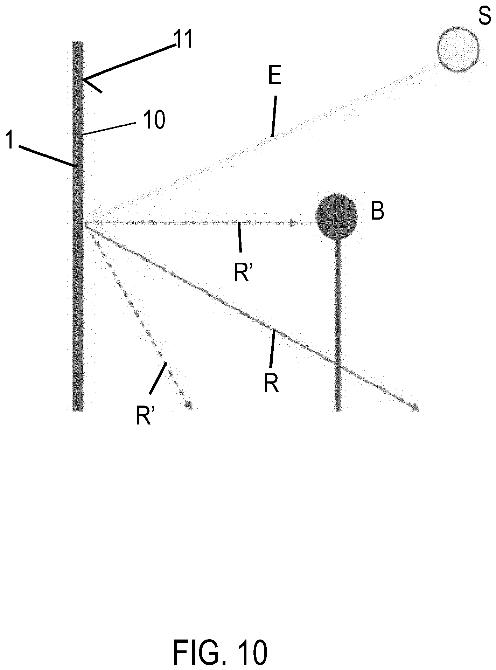

Im Weiteren wird die Funktionsweise der Strukturierung der Außenfläche 11 der Deckplatte 10 näher beschrieben. Sei zunächst Figur 10 betrachtet, worin beispielhaft typische Lichtverhältnisse bei einem als Fassadenelement ausgebildeten Flächenkörper 1 veranschaulicht sind. Demnach trifft Licht von der Sonne S direkt auf die Deckplatte 10 und wird im Glanzwinkel (Einfallswinkel = Ausfallswinkel, bezogen auf Oberflächennormale der Ebene der Deckplatte) reflektiert. Der einfallende Lichtstrahl E und der im Glanzwinkel reflektierte Lichtstrahl R sind gezeigt. Neben dem reflektierten Lichtstrahl R wird das einfallende Licht auch außerhalb des Glanzwinkels diffus gestreut aufgrund der erfindungsgemäßen Konfiguration von mindestens einer strukturierten Seite innen oder außen und der innen liegenden Interferenzschicht. Zwei diffus gestreute Lichtstrahlen R' sind beispielhaft gezeigt. Der Farbeffekt entsteht durch Reflexion, Streuung und Interferenz. Steht ein Beobachter B vor dem Flächenkörper 1 und blickt senkrecht auf die Deckplatte 10 vor ihm, trifft sein Auge nur in den seltensten Fällen das direkt reflektierte Licht R (d.h. der Beobachter steht meist nicht im Glanzwinkel). Dies ist in Figur 10 veranschaulicht, wo sich der Beobachter B außerhalb des Glanzwinkels befindet und nur den diffus gestreuten Lichtstrahl R' sieht. Bei einer glatten Deckplatte ohne strukturierte Bereiche innen oder außen ist die Intensität des diffus gestreuten Lichts R' relativ gering und weist eine sehr starke Winkelabhängigkeit auf. Erst wenn der diffus gestreute Anteil ausreichend groß ist, gibt es eine deutliche Farbe mit zufriedenstellender Intensität (Helligkeit, L-Wert).

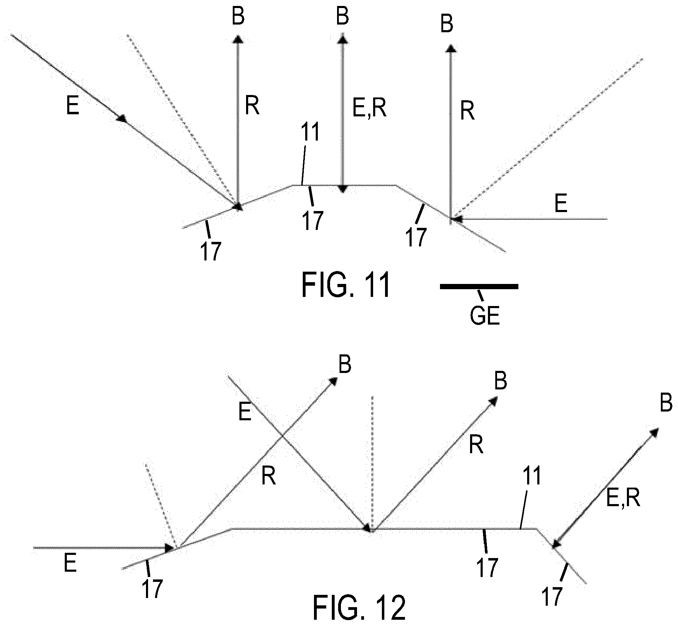

Das Grundprinzip der Wirkungsweise der geneigten Segmente 17 des strukturierten Bereichs 15 ist in Figur 11 veranschaulicht, worin beispielhaft die verschiedenen Lichtwege für einen Beobachter B gezeigt sind, der senkrecht auf die Glasoberfläche bzw. Außenfläche 11 des Flächenkörpers 1 blickt. Gezeigt sind drei Segmente 17 mit verschiedenen Neigungen zur schematisch veranschaulichten Ebene GE der Deckplatte 2, sowie die auf die Segmente 17 treffenden Lichtstrahlen E, die von den Segmenten 17 jeweils im lokalen Glanzwinkel zum Beobachter B reflektiert werden (reflektierte Lichtstrahlen R). Das mittlere Segment 17 ist parallel zur Ebene GE angeordnet, wobei der einfallende Lichtstrahl E senkrecht auf das Segment 17 trifft und senkrecht zum Beobachter B reflektiert wird (reflektierter Strahl R). Für das mittlere Segment 17 sind Glanzwinkel und lokaler Glanzwinkel identisch. Bei den beiden angrenzenden Segmenten 17 haben die einfallenden Lichtstrahlen E jeweils einen von Null verschiedenen Winkel zur Oberflächennormalen auf die Ebene GE und treffen ebenfalls im lokalen Glanzwinkel auf den Beobachter B. Aufgrund der unterschiedlichen Neigungen der Segmente 17 wird Licht aus verschiedenen Richtungen jeweils im lokalen Glanzwinkel der Segmente 17 zu dem senkrecht auf die Modulfläche blickenden Beobachter B reflektiert. Im Ausführungsbeispiel von Figur 11 betragen Ein- und Ausfallswinkel maximal 45°.

In Figur 12 ist eine Situation gezeigt, bei der der Beobachter B in einem Winkel von 45° zur Oberflächennormalen auf die Ebene GE der Deckplatte 10 sieht. Wie in Figur 11 sind beispielhaft drei Segmente 17 mit verschiedenen Neigungen zur Ebene GE der Deckplatte 10 gezeigt, sowie die jeweils auf die Segmente 17 treffenden Lichtstrahlen E, die von den Segmenten 17 im lokalen Glanzwinkel zum Beobachter B reflektiert werden (reflektierte Lichtstrahlen R). Aufgrund der unterschiedlichen Neigungen der Segmente 17 wird Licht aus verschiedenen Richtungen jeweils im lokalen Glanzwinkel zu dem auf die Oberfläche blickenden Beobachter B reflektiert. Im Ausführungsbeispiel von Figur 12 betragen Ein- und Ausfallswinkel maximal 67,5°. Grundsätzlich gilt, dass bei relativ großen Werten des Glanzwinkels das reflektierte Licht n Richtung kürzerer Wellenlängen verschoben ist. Diese Spektralverschiebung kann zum Beispiel durch einen höheren Brechungsindex der optischen Interferenzschicht reduziert werden. Die Auswirkung auf die für das menschliche Auge sichtbare Farbe hängt aber von der komplexen Gewichtung des Spektrums mit den Empfindlichkeitskurven des menschlichen Auges ab. Bei relativ steilen Flächenneigungen kann es auch zur Mehrfach-Reflexion an benachbarten Facetten kommen.

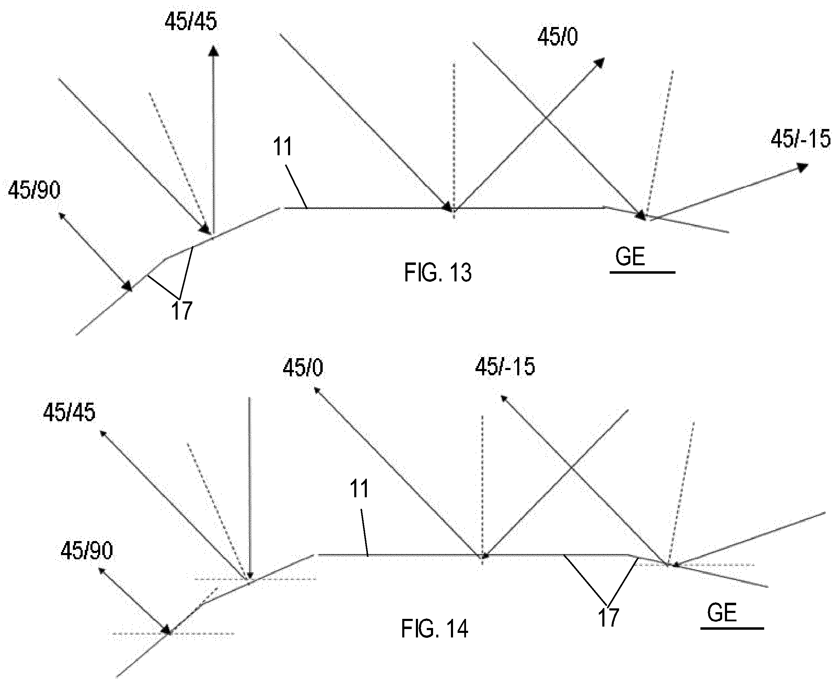

In Figur 13 ist eine Situation gezeigt, bei der die Lichtquelle und dementsprechend die einfallenden Lichtstrahlen stets in einem Winkel von 45° zur Ebene GE der Deckplatte 10 geneigt sind. Der Beobachter B betrachtet die Oberfläche des Flächenkörpers 1 unter verschiedenen Winkeln. Die Winkelangaben in Figur 13 sind wie folgt zu verstehen: Einfallswinkel (bezogen auf Ebene GE der Deckplatte 10) / Beobachtungs- bzw. Reflexionswinkel (Abweichung vom Glanzwinkel bezogen auf Oberflächennormale auf Ebene GE). Das Gradzeichen "°" ist nicht angegeben. In Figur 13 sind beispielhaft vier Segmente 17 mit verschiedenen Neigungen zur Ebene GE gezeigt. Lediglich in einem Segment 17, dessen Ebene parallel zur Ebene der Deckplatte 2 ist, befindet sich der Beobachter B im Glanzwinkel in Bezug auf die Ebene GE: 45/0. Dies bedeutet, dass der einfallende Lichtstrahl einen Winkel von 45° zur Ebene GE hat, der reflektierte Lichtstrahl eine Winkelabweichung Null vom Glanzwinkel. Bei den anderen Segmenten 17 befindet sich der Beobachter B außerhalb des Glanzwinkels. Bei den beiden linken Segmenten 17 (45/90, 45/45) betrachtet der Beobachter die Oberfläche des Flächenkörpers 1 in einem Winkel von 90° bzw. 45° zum Glanzwinkel, wobei das Licht in einem Winkel von 45° zur Ebene GE einfällt. Beim rechten Segment 17 (45/-15) befindet sich der Beobachter in einem Winkel von -15° zum Glanzwinkel. Aufgrund der verschieden geneigten Segmente 17 und der hierdurch bedingten Reflexion im lokalen Glanzwinkel wird auch dann Licht mit hinreichender Intensität zum Beobachter B reflektiert, wenn sich der Beobachter nicht im Glanzwinkel, bezogen auf die Ebene GE der Deckplatte 10, befindet.

In Figur 14 ist eine Situation gezeigt, bei der der Beobachter B die Oberfläche des Flächenkörpers 1 stets in einem Winkel von 45° zur Moduloberfläche bzw. Ebene GE der Deckplatte 10 beobachtet. In Figur 14 sind beispielhaft vier Segmente 17 mit verschiedenen Neigungen zur Ebene GE gezeigt. Lediglich in einem Segment 17, dessen Ebene parallel zur Ebene GE ist, befindet sich der Beobachter B im Glanzwinkel: 45/0. Bei den anderen Segmenten 17 befindet sich der Beobachter B außerhalb des Glanzwinkels. Bei den beiden linken Segmenten 17 (45/90, 45/45) betrachtet der Beobachter B die Oberfläche des Flächenkörpers 1 in einem Winkel von 45°, wobei das Licht in einer Abweichung von 90° bzw. 45° relativ zum Glanzwinkel einfällt. Beim rechten Segment 17 (45/-15) fällt das Licht in einem Winkel von -15° zum Glanzwinkel ein. Aufgrund der verschieden geneigten Segmente 17 und der hierdurch bedingten Reflexion im lokalen Glanzwinkel wird auch dann Licht mit hinreichender Intensität zum Beobachter B reflektiert, wenn Licht außerhalb des Glanzwinkels einfällt.

In dem erfindungsgemäßen Flächenkörper 1 kann durch die Strukturierung der Außenfläche 11 der Deckplatte 10 in Kombination mit der mindestens einen farbgebenden optischen Interferenzschicht 16, 16' ein homogener Farbeeindruck in einem vorgebbaren Wellenlängenbereich erreicht werden, wobei der Farbeindruck im Vergleich zu einer nichtstrukturierten Oberfläche weitaus weniger winkelabhängig ist.

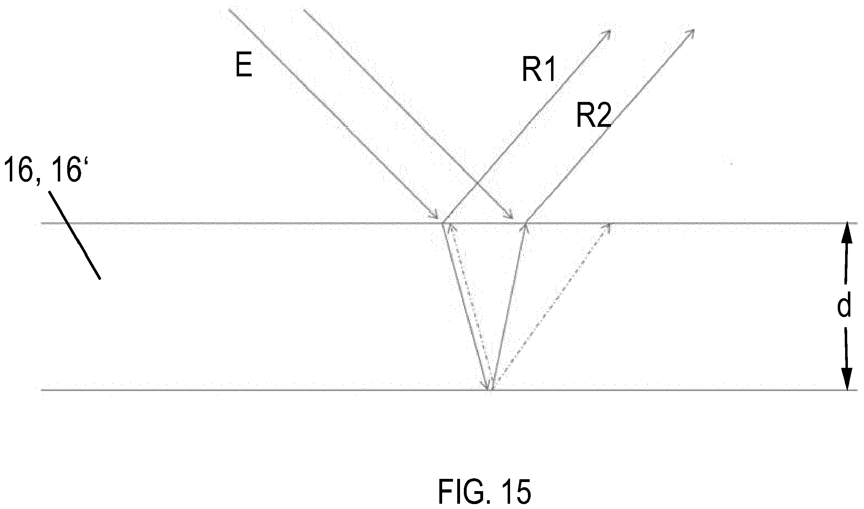

In Figur 15 ist die Reflexion an der optischen Interferenzschicht 16, 16' mit Schichtdicke d veranschaulicht. Der einfallende Lichtstrahl E wird sowohl an der Grenzfläche Atmosphäre-Interferenzschicht (R1) als auch an der Grenzfläche Interferenzschicht-Deckplatte (R2) reflektiert. Falls der Gangunterschied der beiden Lichtstrahlen R1, R2 einem Vielfachen der Wellenlänge des einfallenden Lichtstrahls entspricht, tritt konstruktive Interferenz auf, bei einem Gangunterschied von einem Vielfachen der halben Wellenlänge destruktive Interferenz. Bei Beleuchtung mit weißem Licht wirkt die optische Interferenzschicht 9 somit als Farbfilter, da konstruktive Interferenz, abhängig vom Brechungsindex n und Schichtdicke d, nur für Licht geeigneter Wellenlänge auftritt. Hierbei ist α der Winkel der reflektierten Strahlen R1, R2, zur Oberflächennormalen. Die Lichtstrahlen R' veranschaulichen beispielhaft das reflektierte Licht außerhalb des Glanzwinkels, welche im strukturierten Bereich 15 auftreten können, wenn die Rauigkeit der Grenzfläche zwischen Interferenzschicht-Deckplatte zu groß ist. Um die Interferenzbedingung zu erfüllen, ist es erforderlich, dass die Streuzentren jeweils kleiner als Wellenlänge und Schichtdicke sind. Dies kann durch die erfindungsgemäß beanspruchte Minimalfläche der Segmente 17 und deren maximale Rauigkeit erreicht werden.

Falls die Außenfläche 11 der Deckplatte 10 mit einer optischen Interferenzschicht 16, bestehend aus einer anorganischen, chemisch inerten und harten Schicht wie zum Beispiel mit Si₃N₄, beschichtet ist, ergibt sich eine hohe Kratzfestigkeit, chemische Beständigkeit und schmutzabweisende Wirkung für den Flächenkörper 1. Durch die Verwendung von fotokatalytischen Schichten wie TiO₂ kann sich zudem ein selbstreinigender Effekt ergeben. Klimatests haben auch ergeben, dass Interferenzschichten aus Materialen wie Si₃N₄ oder TiO₂ auch die Korrosion einer gläsernen Deckplatte durch feuchte Hitze unterbinden.

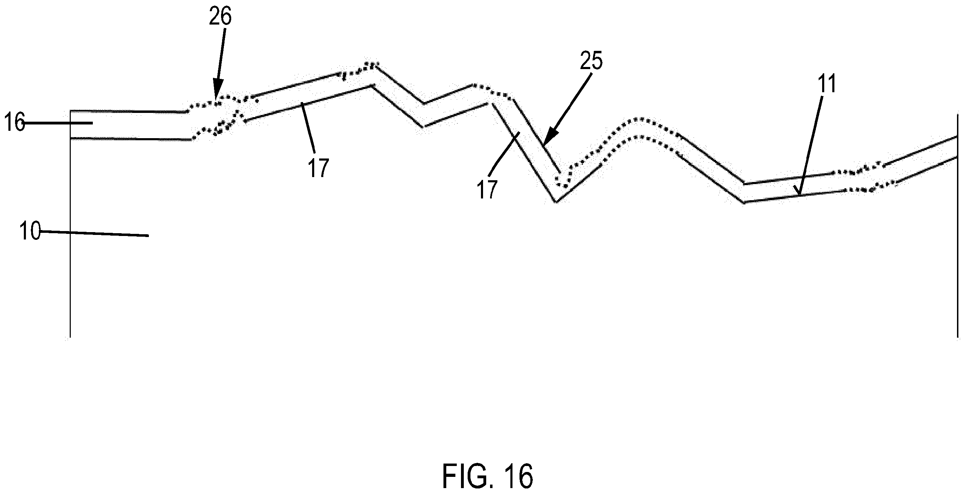

Es wird nun Bezug auf Figur 16 genommen, worin eine Ausgestaltung der Deckplatte 1 veranschaulicht ist. Um unnötige Wiederholungen zu vermeiden, werden nur die Unterschiede zur Ausgestaltung von Figur 5 beschrieben und ansonsten wird auf obige Ausführungen Bezug genommen. Bei dieser Ausgestaltung weist der strukturierte Bereich 15 der Außenfläche 11 erste Zonen 25 und zweite Zonen 26 auf. Hierbei sind die ersten Zonen 25 so ausgebildet, dass die Segmente 17 eine mittlere Rauigkeit haben, die weniger als 15% der Schichtdicke d der optischen Interferenzschicht 16 auf der Außenfläche 11 beträgt. In der Ausgestaltung von Figur 5 gilt dies für den gesamten strukturierten Bereich 15. Im Unterschied hierzu ist die mittlere Rauigkeit in den zweiten Zonen 26 so groß, dass eine Interferenz in der optischen Interferenzschicht 16 unterbunden wird. Beispielsweise beträgt die mittlere Rauigkeit der Segmente 17 in den zweiten Zonen 26 mehr als 50% der Schichtdicke der optischen Interferenzschicht 16. Der Flächenkörper 1 hat deshalb in den ersten Zonen 25 eine homogene Farbe, welche sich aus der Farbfilterwirkung der optischen Interferenzschicht 16 ergibt. In den zweiten Zonen 26 hat die optische Interferenzschicht 16 durch fehlende konstruktive Interferenz keinen Farbfiltereffekt und es somit liegt im Wesentlichen eine Oberfläche vor, die dem Flächenkörper 1 ohne optischer Interferenzschicht 16 entspricht. Der Flächenkörper 1 kann somit wahlfrei in den vorgebbaren ersten Zonen 25 mit einer homogenen Farbe versehen werden. In Figur 16 sind die zweiten Zonen 16 durch eine größere Rauigkeit schematisch veranschaulicht. Aus Gründen einer vereinfachten Darstellung ist der erste Bereich 22, in dem sich keine optische Interferenzschicht 16 befindet, nicht eingezeichnet. Für die mindestens eine weitere optische Interferenzschicht 16' gelten die Ausführungen analog.

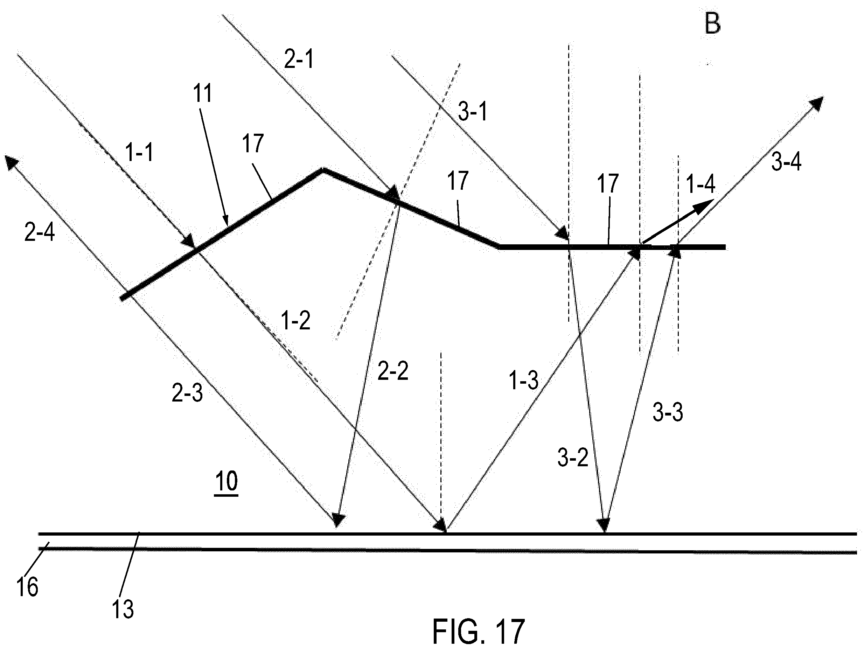

Anhand von Figur 17 wird die Funktion der strukturierten Außenfläche 11 in Kombination mit der innenseitigen Interferenzschicht 16 gemäß der Ausgestaltung von Figur 6 näher erläutert. Aus Gründen einer vereinfachten Darstellung ist der erste Bereich 22, in dem sich keine optische Interferenzschicht 16 befindet, nicht eingezeichnet. Darin gezeigt sind beispielhaft verschiedene Lichtwege für verschieden geneigte Segmente 17 der Deckplatte 10. Beispielhaft sind drei Segmente 17 gezeigt, wobei das rechte Segment 17 parallel zur Ebene der Deckplatte 10 liegt und die beiden anderen Segmente 17 einen von Null verschiedenen Winkel zur Ebene der Deckplatte 10 haben. Die Reflexion der Lichtstrahlen an der Interferenzschicht 16 ist vereinfacht dargestellt. Die Reflexion an der Interferenzschicht 16 ist im Zusammenhang mit Figur 12 erläutert. In Figur 17 sind die Lichtwege für drei Lichtstrahlen gezeigt, die jeweils in einem selben Winkel zur Normalen der Ebene der Deckplatte 10 auf die verschieden geneigten Segmente 17 der Außenfläche 11 der Deckplatte 10 treffen. Das jeweilige Lot auf die Segmente 17 ist gestrichelt eingezeichnet. Aufgrund der verschieden geneigten Segmente 17 werden die Lichtstrahlen in verschiedener Weise reflektiert. Ein erster Lichtstrahl 1-1 trifft auf ein Segment 17, quert als gebrochener Lichtstrahl 1-2 die Deckplatte 2, wird als Lichtstrahl 1-3 von der Interferenzschicht 16 (im Glanzwinkel) reflektiert, und tritt als gebrochener Lichtstrahl 1-4 von der Deckplatte 10 zur äußeren Umgebung hin aus. Der letztlich von der Deckplatte 10 reflektierte Lichtstrahl 1-4 weist einen anderen Winkel zur Normalen auf die Ebene der Deckplatte 10 auf als der einfallende Lichtstrahl 1-1, so dass keine Reflexion im Glanzwinkel sondern Streuung vorliegt. In entsprechender Weise trifft ein zweiter Lichtstrahl 2-1 auf ein anderes Segment 17, quert als gebrochener Lichtstrahl 2-2 die Deckplatte 2, wird als Lichtstrahl 2-3 von der Interferenzschicht 16 reflektiert, und tritt als gebrochener Lichtstrahl 2-4 von der Deckplatte 10 zur äußeren Umgebung hin aus. Der reflektierte Lichtstrahl 2-4 tritt annähernd entgegen der Einfallsrichtung des Lichtstrahls 2-1 von der Deckplatte 10 aus, was ebenfalls ein Streuvorgang und keine Reflexion im Glanzwinkel ist. Ein dritter Lichtstrahl 3-1 trifft auf ein weiteres Segment 17, quert als gebrochener Lichtstrahl 3-2 die Deckplatte 10, wird als Lichtstrahl 3-3 von der Interferenzschicht 16 reflektiert, und tritt als gebrochener Lichtstrahl 3-4 von der Deckplatte 10 zur äußeren Umgebung hin aus. Dieses Segment 17 liegt parallel zur Ebene der Deckplatte 10, so dass der Lichtstrahl 2-4 im Glanzwinkel reflektiert wird. Wesentlich hierbei ist, dass durch jene Segmente 17, die zur Ebene der Deckplatte 10 geneigt sind, aufgrund der Brechung am jeweiligen Segment 17 und anschließende Reflexion an der Grenzfläche mit Interferenzschicht 16 und weiterer Brechung an der strukturierten Oberfläche insgesamt eine starke Reflexion auch au-ßerhalb des Glanzwinkels (bezogen auf die Ebene der Deckplatte 2) auftritt, so dass in Kombination mit der Interferenzschicht 16 eine Farbwirkung des reflektierten Lichts auch außerhalb des Glanzwinkels der Glasebene erreicht wird. In Figur 17 ist beispielhaft die Position eines Betrachters B dargestellt, der sich außerhalb des Glanzwinkels befindet. Aufgrund der relativ stark (diffus) streuenden Deckplatte 10 mit äußerer Strukturierung und innen liegender Interferenzschicht finden sich für verschiedene Betrachtungswinkel außerhalb des Glanzwinkels meist passende Lichtwege, die die Interferenzschicht passiert haben. Hierdurch ergibt sich ein Farbeindruck, der weitaus weniger richtungsabhängig ist als bei herkömmlichen Modulen ohne strukturierten Bereich 15.

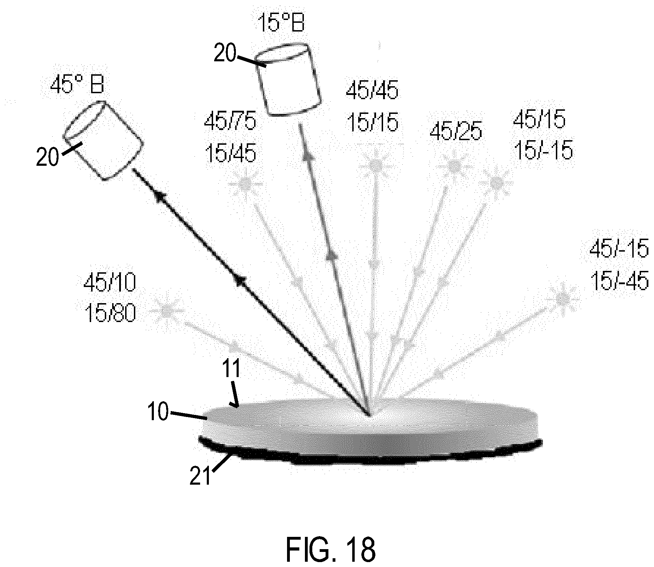

In Figur 18 ist eine Messanordnung zur Bestimmung der diffusen Streuung des erfindungsgemäßen Flächenkörpers 1 mit einem kommerziell verfügbaren Mehrwinkel-Farbmessgerät 20 veranschaulicht (Mehrwinkel-Farbmessung). Der nicht näher dargestellte strukturierte Bereich 15 erstreckt sich über die komplette Deckplatte 10 (z.B. Glas). Hierbei wird ein Lichtstrahl auf die Außenfläche 11 des zu charakterisierenden Fllächenkörpers 1 unter verschiedenen Einfallswinkeln gerichtet und das gestreute bzw. reflektierte Licht aus verschiedenen Beobachtungswinkeln, beispielsweise 15° oder 45° zur Oberflächennormalen der Ebene der Deckplatte 10, spektral vermessen. Unter der Deckplatte 10 befindet sich ein opakes Rückseitenelement 21, das hier beispielsweise als eine schwarze, nicht glänzende Schicht (z.B. angebunden mit einer Flüssigkeit mit Brechungsindex bei etwa 1.5) ausgebildet ist. Mit dem Mehrwinkel-Farb-messgerät 20 kann man die winkelabhängige Helligkeit im L-a-b System bei D65 Norm Beleuchtung und 10° Öffnungswinkel einer unbeschichteten, aber strukturierten Scheibe bestimmen. Es hat sich gezeigt, dass eine gute Winkelstabilität (d.h. geringe Winkelabhängigkeit des gestreuten Lichts) der strukturierten Deckplatte erreicht wird, wenn bei Messung der unbeschichteten Deckplatte (strukturierte Seite in Richtung Messgerät) sowohl bei 45° als auch bei 15° Beobachtungswinkel und bei einem Einfallswinkel von 45°, jeweils gemessen vom Glanzwinkel, noch mindestens eine Helligkeit von L = 10, bevorzugt L = 15 und noch besser L= 20 vorliegt. Durch den mindestens einen strukturierten Bereich 15 von Außenfläche 11 und/oder Innenfläche 13 der Deckplatte 10 kann sowohl bei 45° als auch bei 15° Beobachtungswinkel und bei einem Einfallswinkel von 45°, jeweils gemessen vom Glanzwinkel (in beiden Richtungen), mindestens eine Helligkeit von L = 10 erreicht werden. Die Gradangaben sind folgendermaßen zu verstehen: Reflexionswinkel (bezogen auf Oberflächennormale/Einfallswinkel (bezogen auf Glanzwinkel). Beispielsweise fällt bei einem Beobachtungswinkel von 45° (gemessen relativ zur Oberflächennormalen) und einem Einfallswinkel von 45° (gemessen vom Glanzwinkel) der einfallende Stahl genau senkrecht zur Oberfläche ein (45/45). Bei einem Beobachtungswinkel von 15° und einem Einfallswinkel von 45° liegt die Einfallsrichtung 30° von der Oberflächennormalen auf der gleichen Seite wie die Beobachtungsrichtung (15/45). Das Mehrwinkel-Farb-Messgerät 20 ist bei einem Beobachtungswinkel von 45° bzw. 15° relativ zur Oberflächennormalen positioniert.

Wie sich aus vorstehender Erfindungsbeschreibung ergibt, stellt die Erfindung eine verbesserte Deckplate, einen Flächenkörper mit der verbesserten Deckplatte, sowie Verfahren zu deren Herstellung zur Verfügung, die mindestens zwei sehr homogene, intensiven Farben, bei geringer oder fehlender Richtungsabhängigkeit haben. Die Oberfläche des Flächenkörpers kann mit mindestens zwei Farben versehen werden, so dass farbige Muster und Zeichen, die Informationen codieren, gegen einen andersfarbigen Hintergrund darstellbar sind. Aktive und passive Flächenkörper können kosteneffizient in verschiedenen Formen und Größen hergestellt werden und als integrierte Bestandteile einer Gebäudewand oder einer freistehenden Wand, insbesondere als Fassadenelemente, eingesetzt werden. Aktive und passive Flächenkörper können als Fassadenelemente ästhetisch ansprechend miteinander kombiniert werden. Besonders vorteilhaft können mehrfarbige Solarmodule (Farbgebung durch Inteferenzschicht(en), insbesondere CIGS-Dünnschicht-Solarmodule, zur Verfügung gestellt werden, wobei eine homogene Farbwirkung der Fassade erzielt werden kann. Bei aktiven Flächenkörpern ist der Wirkungsgradverlust akzeptabel. Bei passiven Flächenkörpern kann der Halbleiterschichtstapel durch andere zumeist kostengünstigere Materialien ersetzt und weitere Elemente wie Anschlussdose, Randversiegelung, Kontaktbändchen und Kabel können eliminiert werden. Besonders vorteilhaft ermöglicht die Erfindung die Herstellung von mehrfarbigen Passstücken, die insbesondere für den Übergang zu Öffnungen oder den Gebäudekanten notwendig sind. Passive Flächenkörper können weitgehend den gleichen Farbeindruck unter verschiedenen Lichtverhältnissen liefern wie Solarmodule. Wenn nicht-rechteckförmige Fassadenelemente zur Ergänzung von Solarmodulen gewünscht sind, können passive Flächenkörper weitaus kostengünstiger hergestellt werden als Solarmodule. Die Erfindung stellt somit eine vorteilhafte Neuerung zur Verfügung, welche die Herstellung mehrfarbiger Flächenkörper ermöglicht, die als aktive Flächenkörper einen relativ geringem Wirkungsgradverlust haben. Insbesondere ist die ästhetisch ansprechende Verwendung von aktiven und passiven Flächenkörpern als Fassadenelemente ermöglicht.

### Bezugszeichenliste

1 Flächenkörper
2 Substrat
3 Schichtenaufbau
4 Sonnenlicht
5 Rückelektrodenschicht
6 Absorberschicht
7 Pufferschicht
8 Frontelektrodenschicht
9 Klebeschicht
10 Deckplatte
11 Außenfläche
12 Solarzelle
13 Innenfläche
14 Modulrückseite
15 strukturierter Bereich
16, 16' optische Interferenzschicht
17 Segment
19 schwarze Schicht
20 Mehrwinkel-Farbmessgerät
21 Rückseitenelement
22 erster Bereich
23 zweiter Bereich
24 Maske
25 erste Zone
26 zweite Zone
27 Außenseite
28 Innenseite

## Patentansprüche

1. Verfahren zum Bearbeiten einer transparenten Deckplatte (10) für einen Flächenkörper (1), welches umfasst:
a) Bereitstellen einer transparenten Deckplatte (10) mit einer Außenseite (27), welche einer äußeren Umgebung zugewandt sein soll, und einer gegenüberliegenden Innenseite (28), wobei die Deckplatte (10) einen strukturierten Bereich (15) mit einer lichtstreuenden Struktur in mindestens einer Deckplattenfläche (11, 13), gewählt aus Außenfläche (11) und Innenfläche (13) der Deckplatte (10), aufweist, oder alternativ ein strukturierter Bereich (15) ausgebildet wird,
b) teilflächiges Ausbilden mindestens einer optischen Interferenzschicht (16) auf einer Deckplattenseite (27, 28), gewählt aus Außenseite (27) und Innenseite (28), welches umfasst:
b1) Aufbringen einer Maske (24) auf die Deckplatte (10), wobei in senkrechter Sicht durch die Deckplatte (10) die Maske (24) einen ersten Bereich (22) der Deckplattenfläche (11, 13) der Deckplattenseite (27, 28) nicht überdeckt und einen zweiten Bereich (23) der Deckplattenfläche (11, 13) der Deckplattenseite (27, 28) überdeckt, und der erste Bereich (22) und der zweite Bereich (23) in Überdeckung zu dem, gegebenenfalls noch auszubildenden, strukturierten Bereich (15) angeordnet sind,
b2) Aufbringen mindestens einer optischen Interferenzschicht (16) zur Reflexion von Licht innerhalb eines vorgegebenen Wellenlängenbereichs auf die Deckplatte (10) auf der gewählten Deckplattenseite (27, 28), wobei die optische Interferenzschicht (16) in senkrechter Sicht durch die Deckplatte (10) in Überdeckung zur Maske (24) und in Überdeckung zum ersten Bereich (22) der Deckplattenfläche (11, 13) aufgebracht wird,
b3) Entfernen der Maske (24), wobei die in senkrechter Sicht in Überdeckung zur Maske (24) befindliche optische Interferenzschicht (16) mitentfernt wird.

2. Verfahren nach Anspruch 1, bei welchem mindestens eine weitere optische Interferenzschicht (16') zur Reflexion von Licht innerhalb eines vorgegebenen Wellenlängenbereichs auf die Dickplatte (10) auf der gewählten Deckplattenseite (27, 28) aufgebracht wird, wobei die optische Interferenzschicht (16') in senkrechter Sicht durch die Deckplatte (10) den ersten Bereich (22) und den zweiten Bereich (23) der Deckplattenfläche (11, 13) überdeckt.

3. Verfahren nach Anspruch 1 oder 2, bei welchem eine Deckplatte (10) bereitgestellt wird, welche auf der gewählten Deckplattenseite (27, 28) und/oder der nicht gewählten Deckplattenseite (27, 28) jeweils mindestens eine weitere optische Interferenzschicht (16") zur Reflexion von Licht innerhalb eines vorgegebenen Wellenlängenbereichs aufweist, wobei die optische Interferenzschicht (16") in senkrechter Sicht durch die Deckplatte (10) den ersten Bereich (22) und den zweiten Bereich (23) der Deckplattenfläche (11, 13) der gewählten Deckplattenseite (27, 28) überdeckt.

4. Verfahren nach einem der Ansprüche 1 bis 3, bei welchem das teilflächige Ausbilden der mindestens einen optischen Interferenzschicht (16) ein- oder mehrmalig wiederholt wird.

5. Verfahren nach einem der Ansprüche 1 bis 4, bei welchem die Außenfläche (11) einen strukturierten Bereich (15) aufweist, die Innenfläche (13) keinen strukturierten Bereich aufweist und mindestens eine optische Interferenzschicht (16) teilflächig auf der Innenseite (28) der Deckplatte (10) ausgebildet wird.

6. Verfahren nach einem der Ansprüche 2 bis 5, bei welchem die Deckplatte (10) mindestens zwei optische Interferenzschichten (16, 16', 16") aufweist, die sich in Brechungsindex und/oder Schichtdicke unterscheiden.

7. Verfahren nach einem der Ansprüche 1 bis 6, bei welchem der strukturierte Bereich (15) folgende Merkmale aufweist:
- senkrecht zur Ebene der Deckplatte (10) ein Berge und Täler aufweisendes Höhenprofil, wobei ein mittlerer Höhenunterschied zwischen den Bergen und Tälern mindestens 2 µm beträgt,
- mindestens 50% des strukturierten Bereichs (15) setzt sich aus Segmenten (17) zusammen, die zur Ebene der Deckplatte (10) geneigt sind, wobei, bezogen auf die Ebene der Deckplatte (10), mindestens 20% der Segmente (17) einen Neigungswinkel im Bereich von größer als 0° bis maximal 15° und mindestens 30% der Segmente (17) einen Neigungswinkel im Bereich von größer als 15° bis maximal 45° haben, wobei
- falls die Innenfläche (13) mindestens einen strukturierten Bereich (15) aufweist, die Segmente (17) des strukturierten Bereichs (15) der Innenfläche (13) jeweils eben sind, eine Segmentfläche von mindestens 1 µm² und eine mittlere Rauigkeit von weniger als 15% einer Schichtdicke der optischen Interferenzschicht (16) auf der Innenfläche (13) haben.

8. Verfahren nach Anspruch 7, bei welchem
a) mindestens 80% des strukturierten Bereichs (15) aus zur Ebene der Deckplatte (10) geneigten Segmenten (17) zusammengesetzt ist, und/oder
b1) mindestens 30% der Segmente (17) einen Neigungswinkel im Bereich von größer als 0° bis maximal 15°, mindestens 40% der Segmente (17) einen Neigungswinkel im Bereich von größer als 15° bis maximal 45° und weniger als 10% der Segmente (17) einen Neigungswinkel von größer als 45° haben, oder
b2) mindestens 40% der Segmente (17) einen Neigungswinkel im Bereich von größer als 0° bis maximal 15°, mindestens 50% der Segmente (17) einen Neigungswinkel im Bereich von größer als 15° bis maximal 45° und weniger als 10% der Segmente (17) einen Neigungswinkel von größer als 45° haben.

9. Verfahren nach einem der Ansprüche bis 7 bis 8, bei welchem ein mittlerer Höhenunterschied zwischen den Bergen und Tälern mindestens 50 µm oder mindestens 100 µm beträgt.

10. Verfahren zum Herstellen eines Flächenkörpers (1), welches das Verfahren zum Bearbeiten einer transparenten Deckplatte (10) nach einem der Ansprüche 1 bis 9 umfasst.

11. Transparente Deckplatte (10) für einen Flächenkörper (1), insbesondere bearbeitet durch ein Verfahren nach einem der Ansprüche 1 bis 9, welche eine Außenseite (27), die der äußeren Umgebung zugewandt sein soll, und eine gegenüberliegende Innenseite (28) aufweist, wobei
- mindestens eine Deckplattenfläche (11, 13), gewählt aus Außen- und Innenfläche, einen strukturierten Bereich (15) mit einer lichtstreuenden Struktur aufweist,
- mindestens eine optische Interferenzschicht (16) zur Reflexion von Licht innerhalb eines vorgegebenen Wellenlängenbereichs auf einer Deckplattenseite (27, 28), gewählt aus Außenseite (27) und Innenseite (28), angeordnet ist, wobei die optische Interferenzschicht (16) über einem ersten Bereich (22) der Deckplattenfläche (11, 13) der Deckplattenseite (27, 28) angeordnet ist und über einem zweiten Bereich (23) der Deckplattenfläche (11, 13) der Deckplattenseite (27, 28) nicht angeordnet ist, wobei der erste Bereich (22) und der zweite Bereich (23) in senkrechter Sicht durch die Deckplatte (10) in Überdeckung zum strukturierten Bereich (15) angeordnet sind.

12. Transparente Deckplatte (10) für einen Flächenkörper (1) nach Anspruch 11, welche mindestens eine weitere optische Interferenzschicht (16', 16") auf der gewählten Deckplattenseite (27, 28) aufweist, wobei die optische Interferenzschicht (16', 16") in senkrechter Sicht durch die Deckplatte (10) den ersten Bereich (22) und den zweiten Bereich (23) der Deckplattenfläche (11, 13) der gewählten Deckplattenseite (27, 28) überdeckt.

13. Transparente Deckplatte (10) für einen Flächenkörper (1) nach Anspruch 12, bei welcher sich die mindestens eine weitere optische Interferenzschicht (16', 16") auf einer oder beiden Seiten der teilflächig aufgebrachten optischen Interferenzschicht (16) befindet.

14. Transparente Deckplatte (10) für einen Flächenkörper (1) nach einem der Ansprüche 11 bis 13, welche mindestens eine weitere optische Interferenzschicht (16") auf der nicht gewählten Deckplattenseite (27, 28) aufweist, wobei die optische Interferenzschicht (16") in senkrechter Sicht durch die Deckplatte (10) den ersten Bereich (22) und den zweiten Bereich (23) der Deckplattenfläche (11, 13) der gewählten Deckplattenseite (27, 28) überdeckt.

15. Flächenkörper (1), insbesondere lichtabsorbierender Flächenkörper, insbesondere ein photovolatisches Solarmodul, ein thermischer Solarkollektor oder ein passives farbiges Fassadenelement, welcher eine transparente Deckplatte (10) nach einem der Ansprüche 11 bis 14 umfasst.
